(19) Europäisches Patentamt / European Patent Office / Office européen des brevets

(11) **EP 3 032 244 B1**

(12) **FASCICULE DE BREVET EUROPEEN**

(45) Date de publication et mention de la délivrance du brevet:
**02.08.2017 Bulletin 2017/31**

(51) Int Cl.:
***G01N 23/225*** (2006.01)

(21) Numéro de dépôt: **15198528.0**

(22) Date de dépôt: **08.12.2015**

(54) **PROCÉDÉ D'ÉTUDE D'UNE ZONE D'UN OBJET POUR EN DÉTERMINER UNE ÉPAISSEUR MASSIQUE ET UNE COMPOSITION EN UTILISANT UN FAISCEAU D'ÉLECTRONS ET DES MESURES D'INTENSITÉ D'UN RAYONNEMENT X**

METHODE ZUR BESTIMMUNG DER MASSENDICKE UND DER ZUSAMMENSETZUNG EINER ZONE EINES OBJEKTES MITTELS EINES ELEKTRONENSTRAHLS UND MESSUNGEN DER RÖNTGENINTENSITÄTEN

METHOD FOR THE DETERMINATION OF THE MASS THICKNESS AND THE COMPOSITION OF A ZONE OF AN OBJECT USING AN ELECTRON BEAM AND MEASUREMENTS OF X-RAY INTENSITIES

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **12.12.2014 FR 1462333**

(43) Date de publication de la demande:
**15.06.2016 Bulletin 2016/24**

(73) Titulaire: **COMMISSARIAT À L'ÉNERGIE ATOMIQUE ET AUX ÉNERGIES ALTERNATIVES**
75015 Paris (FR)

(72) Inventeur: **Robin, Eric**
**26210 MANTHES (FR)**

(74) Mandataire: **Novaimo**
**ActiTech 8**
**60 avenue Marie Curie**
**Archamps Technopole**
**74166 Saint Julien en Genevois Cedex (FR)**

(56) Documents cités:
- M. WATANABE ET AL: "The quantitative analysis of thin specimens: a review of progress from the Cliff-Lorimer to the new zeta-factor methods", JOURNAL OF MICROSCOPY, vol. 221, no. 2, février 2006 (2006-02), pages 89-109, XP055197678, ISSN: 0022-2720, DOI: 10.1111/j.1365-2818.2006.01549.x
- RAYNALD GAUVIN: "What remains to be done to allow quantitative X-ray microanalysis performed with EDS to become a true characterization technique?", MICROSCOPY AND MICROANALYSIS, SPRINGER, NEW YORK, NY, US, vol. 18, no. 5, octobre 2012 (2012-10), pages 915-940, XP001578790, ISSN: 1431-9276, DOI: 10.1017/S1431927612001468 [extrait le 2012-10-25]
- PAULA HORNY ET AL: "Development of a New Quantitative X-Ray Microanalysis Method for Electron Microscopy", MICROSCOPY AND MICROANALYSIS, SPRINGER, NEW YORK, NY, US, vol. 16, no. 6, décembre 2010 (2010-12), pages 821-830, XP001559067, ISSN: 1431-9276, DOI: 10.1017/S1431927610094018

## Description

### Domaine technique de l'invention

L'invention concerne le domaine de l'étude d'objet, par exemple par spectrométrie à dispersion d'énergie ou à dispersion de longueur d'onde dans un microscope électronique, dont on cherche à caractériser une zone en déterminant son épaisseur massique et sa composition en termes d'élément(s) chimique(s).

L'invention a pour objet plus particulièrement un procédé d'étude d'une zone de l'objet, ladite zone présentant une épaisseur massique et comportant au moins un élément chimique. Le procédé d'étude utilise pour cela notamment un faisceau d'électrons et des mesures d'intensité d'un rayonnement X issues de l'interaction du faisceau avec ladite zone.

### État de la technique

Pour déterminer la composition d'une lame réalisée en un matériau, notamment homogène, il est connu d'utiliser des mesures par spectrométrie à dispersion d'énergie ou à dispersion de longueur d'onde en utilisant, par exemple, des microscopes électroniques à balayage (MEB) ou à transmission (MET).

Une première méthode connue se limite à étudier un objet, par exemple se présentant sous forme de lame comme évoqué ci-dessus, dont l'épaisseur est telle que le faisceau d'électrons interagissant avec ledit objet est entièrement absorbé par ledit objet. Il est alors supposé que l'épaisseur de la lame est infinie.

Une deuxième méthode connue se limite à étudier un objet, par exemple se présentant sous forme de lame comme évoqué ci-dessus, qui est totalement transparent au faisceau d'électrons utilisé lors de l'étude. Il est alors supposé que l'épaisseur de la lame est nulle.

Ces deux méthodes donnent des résultats approchant mais non satisfaisant. En particulier, ces résultats sont erronés lorsque l'épaisseur de l'objet est telle qu'une partie du faisceau d'électron est transmise par ledit objet.

### Objet de l'invention

Le but de la présente invention est de proposer une solution permettant de prendre en compte l'épaisseur de l'objet sur la zone étudiée.

On tend vers ce but grâce à un procédé d'étude d'une zone d'un objet, ladite zone présentant une épaisseur massique et comportant au moins un élément chimique, ledit procédé comportant :

- une étape d'exposition d'une partie de la zone de l'objet à un faisceau d'électrons,
- une étape d'identification de chaque élément chimique présent dans ladite zone grâce à l'étape d'exposition,
- une étape de mesure, pour chaque élément chimique identifié, d'une intensité correspondante d'un rayonnement X émergent de l'objet du fait de ladite étape d'exposition,
- une étape de détermination d'une valeur de ladite épaisseur massique fonction de chaque étape de mesure,
- une étape de détermination d'une valeur de la concentration de chaque élément chimique identifié utilisant ladite valeur de l'épaisseur massique déterminée.

Le procédé comporte de plus une étape d'initialisation dans laquelle une valeur intermédiaire de l'épaisseur massique $\rho z_0$, avec $\rho$ la densité supposée et $z_0$ l'épaisseur supposée de l'objet au niveau de ladite zone, et une valeur intermédiaire de concentration $C_{ic}$ de chaque élément chimique identifié sont déterminées par choix, notamment en considérant que l'intensité du rayonnement X émergent correspondant est égale à l'intensité du rayonnement généré dans l'objet par ledit élément chimique correspondant, et le procédé comporte un cycle itératif d'étapes comportant pour chaque itération dudit cycle :

- une étape de calcul d'un terme de correction d'incidence $\overline{\Theta}$ destiné à la prise en compte de l'angle d'incidence $\theta$ du faisceau d'électrons et associé à la zone étudiée,
- une étape d'ajustement, mise en oeuvre pour chaque élément chimique identifié, et comprenant :

  ○ une étape de calcul d'un terme de correction d'incidence $\overline{\Theta}_{im}$ associé audit élément chimique identifié et destiné à la prise en compte de l'angle d'incidence $\theta$ du faisceau d'électrons,
  ○ une étape de calcul d'un terme de correction de numéro atomique $\overline{\varphi_i}$ dudit élément chimique correspondant utilisant les termes calculés, au cours dudit cycle, de correction d'incidence $\overline{\Theta}$ et $\overline{\Theta}_{im}$,
  ○ une étape de calcul d'un terme de correction d'absorption $\overline{\chi_i}$ dudit élément chimique correspondant utilisant les termes calculés, au cours dudit cycle, de correction d'incidence $\overline{\Theta}$ et $\overline{\Theta}_{im}$ et le terme calculé, au cours dudit cycle, de correction de numéro atomique $\overline{\varphi_i}$,

- une étape de modification de la valeur intermédiaire d'épaisseur massique $\rho z_0$ utilisant le terme, calculé au cours dudit cycle, de correction d'incidence $\overline{\Theta}$, et les termes de correction d'incidence $\overline{\Theta_{im}}$, de correction de numéro atomique $\overline{\varphi_i}$ et de correction d'absorption $\overline{\chi_i}$ calculés au cours dudit cycle pour chaque élément chimique et fonction de chaque étape de mesure,
- une étape de modification, pour chaque élément chimique, de la valeur intermédiaire de concentration $C_{ic}$ dudit élément chimique correspondant utilisant la valeur intermédiaire d'épaisseur massique $\rho z_0$ telle que modifié au cours dudit cycle, le terme, calculé au cours dudit cycle, de correction d'incidence $\overline{\Theta}$ et les termes de correction d'incidence $\overline{\Theta_{im}}$, de correction de numéro atomique $\overline{\varphi_i}$ et de correction d'absorption $\overline{\chi_i}$ calculés au cours dudit cycle et correspondants audit élément chimique,

et l'itération est stoppée lorsque la variation, entre deux itérations successives des valeurs intermédiaires d'épaisseur massique $\rho z_0$ et des valeurs intermédiaires de concentration $C_{ic}$ de chaque élément chimique, est inférieure à un seuil prédéterminé associé, ladite valeur d'épaisseur massique intermédiaire modifiée définissant la valeur d'épaisseur massique déterminée et chaque valeur intermédiaire de concentration modifiée définissant la valeur de concentration déterminée correspondante.

Selon une réalisation, chaque étape de calcul du terme de correction d'incidence $\overline{\Theta}$ comprend la résolution de l'équation suivante :

$$\bar{\Theta} = \left\{ 1 + \left[ \frac{\rho z_0}{\cos\theta} f(\mathbb{Z}_c) - 2\frac{\cos\theta}{\rho}\left(1 - e^{14(1-\rho)\frac{\rho z_0}{\cos\theta}f(\mathbb{Z}_c)}\right) e^{-2\frac{\rho z_0}{\cos\theta}f(\mathbb{Z}_c)} \right] \left[ \frac{1}{\cos\theta} - 1 \right] \right\}^{0.6}$$

et chaque étape de calcul du terme de correction d'incidence $\overline{\Theta_{im}}$ comprend la résolution de l'équation suivante :

$$\bar{\Theta}_{im} = \left\{ 1 + \left[ \frac{\rho z_{im}}{\cos\theta} f_m(E_{is}) - 2\frac{\cos\theta}{\rho} e^{-2\frac{\rho z_{im}}{\cos\theta}f_m(E_{is})} \right] \left[ \frac{1}{\cos\theta} - 1 \right] \right\}^{0.6}$$

avec $Z_c$ le numéro atomique moyen de l'objet au niveau de ladite zone, $f(Z_c)$ une fonction du numéro atomique moyen $Z_c$, $z_{im}$ la profondeur maximale d'ionisation de l'élément chimique correspondant, $f_m(E_{is})$ une fonction de l'énergie seuil d'ionisation $E_{is}$ du niveau d'énergie considéré d'un élément chimique correspondant.

Par exemple, on a $f(Z_c) = e^{a(LnZ_C)^4 + b(LnZ_C)^3 + c(LnZ_C)^2 + d(LnZ_C) + e}$, avec a, b, c, d, e des paramètres déterminés par simulation de Monte-Carlo et dépendant de l'énergie des électrons dudit faisceau d'électrons.

Notamment, $f_m(E_{is}) = \frac{A E_{is}^m}{(R_p/S_p)_i}$ avec $(R_p/S_p)_i$ étant le rapport des coefficients de rétrodiffusion $R_p$ et du pouvoir d'arrêt $S_p$ pour l'élément chimique pur correspondant, et A et m des paramètres déterminés par simulation de Monte-Carlo et dépendant du niveau d'énergie pour ledit élément chimique correspondant.

Selon une réalisation, chaque étape de calcul du terme de correction de numéro atomique $\overline{\varphi_i}$ utilise la relation suivante $\overline{\varphi}_i(\rho z_\theta) = \frac{1 + \alpha(\rho z_\theta)^n}{1 + \frac{\alpha C_{ic}}{\xi_i I_{igco}}\frac{(\rho z_\theta)^{(1+n)}}{(1 + \frac{\beta_i}{(\rho z_\theta)^n})}}$ avec $I_{igco}$ l'intensité par unité de temps d'un rayonnement X généré par l'élément chimique correspondant dans l'objet considéré comme opaque audit faisceau d'électron, $\xi_i$ le zêta-facteur associé audit élément chimique correspondant, $n$ un paramètre dépendant du numéro atomique moyen Zc de l'objet au niveau de ladite zone, $\alpha$ un paramètre dépendant du numéro atomique moyen Zc de l'objet au niveau de ladite zone, $\beta_i$ un terme permettant d'ajuster le maxima du terme $\overline{\varphi_i}$ et $z_\theta$ l'épaisseur selon la direction d'incidence $\theta$ déterminée à partir des termes, calculés au cours dudit cycle, de correction d'incidence $\overline{\Theta}$ et $\overline{\Theta_{im}}$.

Par exemple, le paramètre $n$ est déterminé par la relation suivante $n = n_1 LnZ_c + n_2$, les paramètres $n_1$ et $n_2$ étant donnés par un abaque donnant la valeur de $n$ en fonction de $Z_c$ quelle que soit la puissance du faisceau d'électrons.

Par exemple, le paramètre $\alpha$ est déterminé par la relation suivante $\alpha = e^{(\alpha_1(LnZ_C)^2 + \alpha_2(LnZ_C) + \alpha_3)}$, avec $\alpha_1$, $\alpha_2$ et

$\alpha_3$ des paramètres dépendant de l'énergie initiale $E_0$ des électrons du faisceau d'électrons.

Selon une réalisation, le terme $\beta_i$ est déterminé en posant que, pour toute épaisseur supérieure ou égale à une profondeur maximale d'ionisation $z_{im}$ de l'élément chimique correspondant, l'intensité du rayonnement X généré dans l'objet est équivalente à celle de l'objet si ce dernier est opaque audit faisceau d'électrons.

En particulier, selon ladite réalisation, le terme $\beta_i$ est obtenu par la résolution de l'équation suivante :

$$\beta_i = \begin{cases} (\rho z_{im})^n \dfrac{\left(\frac{\xi_i}{C_{ic}} \frac{I_{igco}}{\rho z_{im}} - 1\right)}{\alpha (\rho z_{im})^n - \left(\frac{\xi_i}{C_{ic}} \frac{I_{igco}}{\rho z_{im}} - 1\right)}, & si\ \beta_i > 0 \\ \\ 0, & si\ \beta_i \le 0 \end{cases}$$

, avec $z_{im}$ la profondeur maximale d'ionisation de l'élément chimique correspondant.

Selon une mise en oeuvre, chaque étape de calcul du terme de correction d'absorption $\overline{\chi_i}$ utilise la résolution de l'équation

$$\bar{\chi}_i =$$

$$\begin{cases} \dfrac{\chi_{ic} \rho z_0 \overline{\varphi}_i(\rho z_\theta)}{\varphi_i(0) + \frac{P_i}{\chi_{ic}} + \left\{P_i'\left(\frac{1}{\chi_{ic}} - \rho z_0\right) - \left[\varphi_i(0) - \varphi_i(\rho z_0) + \frac{P_i}{\chi_{ic}}\right] + (P_i' - P_i)\rho z_{ib}\right\} e^{-\chi_{ic}\rho z_{ib}} - \left[\varphi_i(\rho z_0) + \frac{P_i'}{\chi_{ic}}\right] e^{-\chi_{ic}\rho z_0}}, & si\ z_{ib} > 0 \\ \\ \dfrac{\rho z_0 \chi_{ic} \overline{\varphi}_i(\rho z_\theta)}{\varphi_i(0) + \frac{P_i''}{\chi_{ic}} - \left\{P_i''\left(\frac{1}{\chi_{ic}} + \rho z_0\right) + \varphi_i(0)\right\} e^{-\chi_{ic}\rho z_0}}, & si\ z_{ib} \le 0 \end{cases}$$

avec $\varphi_i(0)$ la valeur de la distribution des intensités du rayonnement X généré en surface de l'objet par l'élément chimique correspondant, $\varphi_i(\rho z_0)$ la valeur de la distribution des intensités du rayonnement X généré à la profondeur $z_0$ de l'objet par l'élément chimique correspondant, $P_i$ la pente initiale de la distribution des intensités du rayonnement X généré en surface de l'objet par l'élément chimique correspondant et déterminée par la relation $P_i = \dfrac{g.h^4.(F/\overline{R})^2}{\overline{\varphi}_i(\rho z_{i\theta})\rho z_{i\theta}} \dfrac{1}{(\cos\theta)^4}$, avec

$$\overline{\varphi}_i(\rho z_{i\theta}) = \frac{1 + \alpha(\rho z_{i\theta})^n}{1 + \frac{\alpha C_{ic}}{\xi_i I_{igco}} \frac{(\rho z_{i\theta})^{(1+n)}}{(1 + \frac{\beta_i}{(\rho z_{i\theta})^n})}} \quad et \quad Z_{i\theta} = \frac{z_{im}}{\overline{\theta}_{im}\cos\theta},$$ $\chi_{ic}$ représentant le coefficient d'absorption massique du composé pour le rayonnement X caractéristique de l'élément chimique correspondant, $\overline{\varphi}_i(\rho z_\theta)$ étant le terme de correction de numéro atomique calculé au cours dudit cycle, $P_i' = \dfrac{[\varphi_i(0) - \varphi_i(\rho z_0)]^2 + 2P_i \rho z_0 [\overline{\varphi}_i(\rho z_\theta) - \varphi_i(\rho z_0)]}{\rho z_0 [2\overline{\varphi}_i(\rho z_\theta) - 2\varphi_i(0) - P_i \rho z_0]}$,

$P_i'' = 2\dfrac{\overline{\varphi}_i(\rho z_\theta) - \varphi_i(0)}{\rho z_0}$, $z_{ib} = z_0 \dfrac{2\overline{\varphi}_i(\rho z_\theta) - \varphi_i(0) - \varphi_i(\rho z_0)}{P_i \rho z_0 + \varphi_i(0) - \varphi_i(\rho z_0)}$, $z_{im}$ la profondeur maximale d'ionisation de l'élément

chimique correspondant, $\beta_i$ un terme permettant d'ajuster le maxima du terme de correction de numéro atomique, $I_{igco}$ l'intensité par unité de temps d'un rayonnement X généré par l'élément chimique correspondant dans l'objet considéré comme opaque audit faisceau d'électron, $\xi_i$ le zêta-facteur associé audit élément chimique correspondant, $\alpha$ un paramètre dépendant du numéro atomique moyen $Z_c$ de l'objet au niveau de ladite zone , n un paramètre dépendant du numéro atomique moyen $Z_c$ de l'objet au niveau de ladite zone et $z_\theta$ la profondeur de l'objet au niveau de ladite zone en tenant compte de l'incidence $\theta$ du faisceau d'électrons.

Notamment, le paramètre $\varphi_i(0)$ peut être calculé de la manière suivante :

$$\varphi_i(0) = \begin{cases} 1 + [\varphi_{im}(0) - 1]\frac{z_0}{\overline{z}_i}, & si\ z_0 < \overline{z}_i \\ \varphi_{im}(0), & si\ z_0 \ge \overline{z}_i \end{cases}$$ avec $\quad \overline{z}_i = \overline{z}_{ip} \dfrac{\rho_i}{\rho} \dfrac{n}{n_i}\Big[1 +$

$0.048\left(2.5 - \frac{E_0}{20}\right)\left(1 - LnM_i + \frac{(LnM_i)^2}{3}\right)\left(\frac{M_c}{M_i} - 1\right)\Big]$, $\varphi_{im}(0)$ l'ionisation de surface de l'élément chimique correspondant dans l'objet considéré comme opaque audit faisceau d'électron , $\bar{z}_{ip}$ l'épaisseur pour laquelle le terme de correction de numéro atomique $\bar{\varphi}_i$ de l'élément chimique pur correspondant est maximum, $n$ et $n_i$ des paramètres dépendant respectivement du nombre atomique moyen de l'objet et du nombre atomique de l'élément chimique pur, $\rho_i$ la densité de l'élément chimique pur correspondant et $M_c$ et $M_i$ les masses atomiques de l'objet et de l'élément chimique pur correspondant, et $E_0$ l'énergie initiale des électrons du faisceau d'électrons.

Le procédé peut comporter une étape de détermination d'un paramètre $\bar{z}_{i\theta}$ correspondant à la valeur minimum entre $\bar{z}_i$ et $z_{i\theta}$ et défini par la relation suivante : $\bar{z}_{i\theta} = Min(\bar{z}_i, z_{i\theta})$.

En particulier, le terme $\varphi_i(\rho z_0)$ est déterminé de la manière suivante :

$$\varphi_i(\rho z_0) = \begin{cases} \left\{\left[\frac{3}{2} - \varphi_i(0)\right]\frac{z_0}{\bar{z}_{i\theta}}\left[2 - \frac{z_0}{\bar{z}_{i\theta}}\right] + \varphi_i(0)\right\}cos\theta, & si \ \ z_0 < \bar{z}_{i\theta} \\ \frac{3}{2}\left\{\left[\frac{z_0-\bar{z}_{i\theta}}{z_{im}-\bar{z}_{i\theta}}\right]\left[\frac{z_0-\bar{z}_{i\theta}}{z_{im}-\bar{z}_{i\theta}} - 2\right] + 1\right\}cos\theta, & si \ \ \bar{z}_{i\theta} \leq z_0 \leq z_{im} \\ 0 & si \ \ z_0 > z_{im} \end{cases}$$

Selon une variante, l'angle d'incidence $\theta$ étant nul alors les deux termes de correction d'incidence $\overline{\Theta}$ et $\overline{\Theta_{im}}$ sont égaux à 1 de telle sorte que le terme de correction de numéro atomique est déterminé à partir de l'équation suivante

$$\bar{\varphi}_i(\rho z_0) = \frac{1 + \alpha(\rho z_0)^n}{1 + \frac{\alpha\, C_{ic}}{\xi_i\, I_{igco}}\frac{(\rho z_0)^{(1+n)}}{(1+\frac{\beta_i}{(\rho z_0)^n})}}$$

avec $I_{igco}$ l'intensité par unité de temps d'un rayonnement X généré par l'élément chimique correspondant dans l'objet considéré comme opaque audit faisceau d'électrons, $\xi_i$ le zêta-facteur associé audit élément chimique correspondant, $n$ un paramètre dépendant du numéro atomique moyen Zc de l'objet au niveau de ladite zone, $\alpha$ un paramètre dépendant du numéro atomique moyen Zc de l'objet au niveau de ladite zone, $\beta_i$ un terme permettant d'ajuster le maxima du terme $\bar{\varphi}_i$, et en ce que $\overline{\chi_i} =$

$$\begin{cases} \dfrac{\chi_{ic}\rho z_0\bar{\varphi}_i(\rho z_0)}{\varphi_i(0)+\frac{P_i}{\chi_{ic}}+\left\{P_i'\left(\frac{1}{\chi_{ic}}-\rho z_0\right)-\left[\varphi_i(0)-\varphi_i(\rho z_0)+\frac{P_i}{\chi_{ic}}\right]+(P_i'-P_i)\rho z_{ib}\right\}e^{-\chi_{ic}\rho z_{ib}}-\left[\varphi_i(\rho z_0)+\frac{P_i'}{\chi_{ic}}\right]e^{-\chi_{ic}\rho z_0}}, & si \ z_{ib} > 0 \\[4mm] \dfrac{\rho z_0\chi_{ic}\bar{\varphi}_i(\rho z_0)}{\varphi_i(0)+\frac{P_i''}{\chi_{ic}}-\left\{P_i''\left(\frac{1}{\chi_{ic}}+\rho z_0\right)+\varphi_i(0)\right\}e^{-\chi_{ic}\rho z_0}}, & si \ z_{ib} \leq 0 \end{cases}$$

avec $\varphi_i(\rho z_0) = \begin{cases} \left[\frac{3}{2} - \varphi_i(0)\right]\frac{z_0}{\bar{z}_i}\left[2 - \frac{z_0}{\bar{z}_i}\right] + \varphi_i(0), & si \ \ z_0 < \bar{z}_i \\ \frac{3}{2}\left\{\left[\frac{z_0-\bar{z}_i}{z_{im}-\bar{z}_i}\right]\left[\frac{z_0-\bar{z}_i}{z_{im}-\bar{z}_i} - 2\right] + 1\right\}, & si \ \ \bar{z}_i \leq z_0 \leq z_{im} \\ 0 & si \ \ z_0 > z_{im} \end{cases}$, $\varphi_i(0)$ la valeur de la distribution des intensités du rayonnement X généré en surface de l'objet par l'élément chimique correspondant, $P_i$ la pente initiale de la distribution des intensités du rayonnement X généré en surface de l'objet par l'élément chimique correspondant et déterminé par la relation $P_i = \frac{g.h^4.(F/\bar{R})^2}{\bar{\varphi}_i(\rho z_{im})\rho z_{im}}$ avec $\bar{\varphi}_i(\rho z_{im}) = \frac{1 + \alpha(\rho z_{im})^n}{1 + \frac{\alpha\, C_{ic}}{\xi_i\, I_{igco}}\frac{(\rho z_{im})^{(1+n)}}{(1+\frac{\beta_i}{(\rho z_{im})^n})}},$ $\chi_{ic}$ représentant le coefficient d'absorption massique de l'objet pour l'élément chimique correspondant

$P_i' = \frac{[\varphi_i(0)-\varphi_i(\rho z_0)]^2 + 2P_i\rho z_0[\bar{\varphi}_i(\rho z_0)-\varphi_i(\rho z_0)]}{\rho z_0[2\bar{\varphi}_i(\rho z_0)-2\varphi_i(0)-P_i\rho z_0]},$ $\qquad P_i'' = 2\frac{\bar{\varphi}_i(\rho z_0)-\varphi_i(0)}{\rho z_0},$ $\qquad$ et

$$z_{ib} = z_0 \frac{2\overline{\varphi}_i(\rho z_0) - \varphi_i(0) - \varphi_i(\rho z_0)}{P_i \rho z_0 + \varphi_i(0) - \varphi_i(\rho z_0)},$$ $z_{im}$ la profondeur maximale d'ionisation de l'élément chimique correspondant,

$$\overline{z}_i = \overline{z}_{ip} \frac{\rho_i}{\rho} \frac{n}{n_i} \left[1 + 0.048 \left(2.5 - \frac{E_0}{20}\right)\left(1 - LnM_i + \frac{(LnM_i)^2}{3}\right)\left(\frac{M_c}{M_i} - 1\right)\right],$$ $\overline{z}_{ip}$ l'épaisseur pour laquelle le terme de correction de numéro atomique $\overline{\varphi}_i$ de l'élément chimique pur correspondant est maximum, $n$ et $n_i$ des paramètres dépendant respectivement du numéro atomique moyen de l'objet et du numéro atomique de l'élément pur correspondant, $\rho_i$ la densité de l'élément chimique pur correspondant et $M_c$ et $M_i$ les masses atomiques de l'objet et de l'élément chimique pur correspondant, $E_0$ l'énergie initiale des électrons du faisceau d'électrons, $\beta_i$ un terme permettant d'ajuster le maxima du terme de correction de numéro atomique, $I_{igco}$ l'intensité par unité de temps d'un rayonnement X généré par l'élément chimique correspondant dans l'objet considéré comme opaque audit faisceau d'électron, $\xi_i$ le zêta-facteur associé audit élément chimique correspondant, $\alpha$ un paramètre dépendant du numéro atomique moyen Zc de l'objet au niveau de ladite zone (Z1), $n$ un paramètre dépendant du numéro atomique moyen Zc de l'objet au niveau de ladite zone.

Préférentiellement, au cours de chaque cycle la valeur intermédiaire de l'épaisseur massique est modifiée selon la formule suivante $\rho z_0 = \overline{\Theta} \cos\theta \sum_{i=1}^{N} \xi_i \frac{\overline{\chi_i} I_{iec}}{\overline{\varphi_i}}$ avec N le nombre total d'éléments chimiques identifiés, i l'index de l'élément chimique courant étudié, $I_{iec}$ l'intensité du rayonnement X émergent correspondant audit élément chimique d'index i, $\overline{\chi_i}$ le terme de correction d'absorption calculé au cours dudit cycle et correspondant audit élément chimique d'index i, $\xi_i$ le zêta-facteur associé audit élément chimique d'index i, le terme de correction de numéro atomique $\overline{\varphi_i}$ calculé au cours dudit cycle et correspondant audit élément chimique d'index i, $\overline{\Theta}$ le terme de correction d'incidence calculé au cours dudit cycle

Préférentiellement, au cours de chaque cycle la valeur intermédiaire de concentration $C_{ic}$ de chaque élément chimique est calculée selon la formule suivante : $C_{ic} = \frac{\xi_i}{\rho z_0} \frac{\overline{\chi_i} I_{iec}}{\overline{\varphi_i}} \overline{\Theta} \cos\theta$ avec $I_{iec}$ l'intensité mesurée du rayonnement X émergent dudit élément chimique correspondant, $\rho z_0$ la valeur intermédiaire d'épaisseur massique modifiée au cours dudit cycle, $\overline{\chi_i}$ le terme de correction d'absorption dudit élément chimique correspondant calculé au cours dudit cycle, $\xi_i$ le zêta-facteur associé audit élément chimique correspondant, le terme de correction de numéro atomique $\overline{\varphi_i}$ calculé au cours dudit cycle dudit élément chimique correspondant, $\overline{\Theta}$ le terme de correction d'incidence calculé au cours dudit cycle.

L'invention est aussi relative à un procédé d'étude d'un objet comportant les étapes suivantes :

- Diviser l'objet en plusieurs zones à étudier,

- Mettre en oeuvre, pour chaque zone, ledit procédé d'étude de la zone décrit ci-avant, en vue de déterminer la valeur d'épaisseur massique correspondante et, pour chaque élément de ladite zone, la valeur de concentration correspondante.

## Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :

- la figure 1 illustre schématiquement différentes étapes d'un procédé d'étude selon un mode d'exécution de l'invention,
- la figure 2 est une vue schématique de l'interaction d'un faisceau d'électrons avec un objet,
- la figure 3 illustre différentes étapes du procédé d'étude,
- la figure 4 illustre une manière de déterminer des paramètres d'une fonction $f(Z_c)$ par simulation de Monte-Carlo,
- la figure 5 illustre une manière de déterminer des paramètres d'une fonction $f_m(E_{is})$ par simulation de Monte-Carlo, lesdits paramètres dépendant du niveau d'émission K, L ou M,
- la figure 6 illustre la variation du paramètre n en fonction du numéro atomique moyen Zc pour différentes puissances du faisceau d'électrons,
- la figure 7 illustre la variation du paramètre $\alpha$ en fonction du numéro atomique moyen Zc pour différentes puissances du faisceau d'électrons,
- la figure 8 est une simulation du terme de correction de numéro atomique $\varphi_i$ fonction de l'épaisseur totale d'un objet sous forme de lame, les points sont calculés en utilisant des intensités du rayonnement X généré par simulation de Monte-Carlo et les courbes en pointillés représente ce qu'il est possible d'obtenir en utilisant le modèle du procédé d'étude selon un mode d'exécution de l'invention.

**Description de modes préférentiels de l'invention**

Le procédé d'étude d'une zone décrit ci-après diffère de l'art antérieur en ce que l'épaisseur de l'objet à étudier va être déterminée (c'est-à-dire non considérée comme nulle ou infinie).

En ce sens, l'invention est relative à un procédé d'étude d'une zone d'un objet, ladite zone présentant une épaisseur massique et comportant au moins un élément chimique. Le ou les élément(s) chimique(s) seront identifiés au cours du procédé d'étude. Notamment, dans la présente description, lorsque l'on parle d'un élément chimique, il s'agit d'un élément chimique identifié.

Dans la présente description, par « élément chimique » on entend un élément de la classification périodique des éléments.

De manière générale, dans la présente description, lorsqu'un terme ou un paramètre comporte l'indice i, on considère qu'il s'agit d'un terme ou d'un paramètre lié audit élément chimique correspondant à cet indice i, i allant alors de 1 à N avec N le nombre total d'éléments chimiques identifiés.

L'objet peut être une lame d'épaisseur constante ou variable.

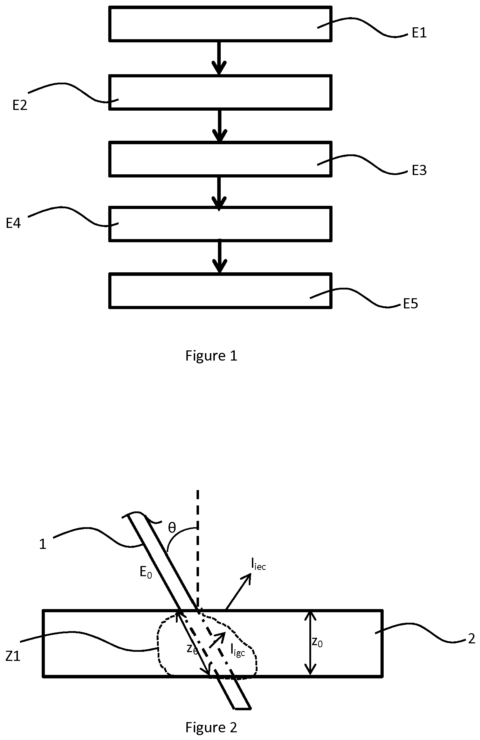

Comme illustré en figure 1, le procédé d'étude comporte une étape d'exposition E1 d'une partie de la zone de l'objet à un faisceau d'électrons. De préférence, au contraire de l'art antérieur, cette étape d'exposition est réalisée de telle sorte que le faisceau d'électrons soit partiellement transmis par l'objet.

La figure 2 illustre un exemple dans lequel un faisceau d'électrons 1 d'énergie $E_0$ vient interagir avec ladite partie de la zone Z1 étudiée de l'objet 2 selon un angle d'incidence $\theta$. Cet angle d'incidence $\theta$ est donné selon la normale par rapport à la surface extérieure de l'objet 2 impactée par le faisceau d'électrons 1. En particulier, à la figure 2, une partie du faisceau d'électrons 1 est transmise par l'objet 2. Il résulte de l'interaction du faisceau d'électrons 1 avec la partie de la zone Z1, la génération de rayonnements X additionnels qui vont se propager dans la zone étudiée. En particulier, chaque élément chimique i présent dans la zone étudiée va générer un rayonnement X d'intensité $I_{igc}$ qui va se propager dans la zone étudiée et dont une partie sera absorbée par l'élément chimique i de la zone et une autre partie sera transmise hors de l'objet de sorte à former un rayonnement X émergent $I_{iec}$. On comprend donc pourquoi la zone étudiée est plus importante que la partie de la zone interagissant directement avec le faisceau d'électrons 1.

Il résulte de ce qui a été dit ci-dessus que lorsque le faisceau d'électrons présente une incidence d'angle $\theta$, cette incidence est associée à une épaisseur $z_\theta$ traversée de l'objet qui est en fait l'épaisseur de l'objet le long d'un axe selon lequel le faisceau d'électrons s'étend. L'angle $\theta$ est donné entre l'axe du faisceau d'électrons et la normale au niveau du point d'impact du faisceau d'électrons sur l'objet. Cette épaisseur $z_\theta$ est supérieure à l'épaisseur réelle de l'objet $z_0$ qui est elle donnée selon la normale de la surface extérieure de l'objet. Cette épaisseur $z_\theta$ peut encore être définie comme la profondeur de l'objet au niveau de ladite zone étudiée en tenant compte de l'incidence $\theta$ du faisceau d'électrons.

Le procédé d'étude comporte en outre une étape d'identification E2 de chaque élément chimique présent dans ladite zone Z1 grâce à l'étape d'exposition E1. En fait, en utilisant des techniques de spectrométrie donnant un nombre de coups par secondes en fonction de l'énergie, il est possible de connaître quels sont les éléments chimiques présents dans la zone Z1 concernée de l'objet 2. On connait alors la composition générale au niveau de la zone Z1 mais sans connaître les pourcentages correspondants. Ceci peut, par exemple, être mis en oeuvre par spectrométrie à dispersion d'énergie notamment dans un microscope électronique à balayage.

En ce sens, le procédé d'étude de la zone Z1 va chercher à déterminer l'épaisseur massique de l'objet 2 au niveau de la zone étudiée Z1 puis à déterminer la concentration de chaque élément chimique identifié. Pour cela, le procédé d'étude de la zone Z1 de l'objet 2 comporte une étape de mesure E3, pour chaque élément chimique identifié, d'une intensité correspondante d'un rayonnement X émergent $I_{iec}$ de l'objet 2 du fait de ladite étape d'exposition, une étape de détermination E4 d'une valeur de ladite épaisseur massique fonction de chaque étape de mesure, et une étape de détermination E5 d'une valeur de la concentration de chaque élément chimique identifié utilisant ladite valeur de l'épaisseur massique déterminée.

La mesure de chaque intensité du rayonnement X émergent $I_{iec}$ est notamment réalisée par spectrométrie à dispersion d'énergie ou à dispersion de longueur d'onde.

Par « valeur de l'épaisseur massique déterminée », on entend une valeur de l'épaisseur massique réelle de l'objet que l'on obtient notamment par calcul.

On comprend donc que le procédé d'étude de la zone Z1 de l'objet 2 permet de prendre en compte l'épaisseur massique dans le cadre de la détermination de la concentration de chaque élément chimique.

La méthode mise en oeuvre dans le présent procédé d'étude permettant de déterminer la valeur de l'épaisseur massique et la valeur de la concentration de chaque élément chimique identifié utilise avantageusement un principe d'approximation itérative. En ce sens, on va choisir, soit de manière arbitraire, soit sur la base d'hypothèses, une valeur intermédiaire d'épaisseur massique et une valeur intermédiaire de concentration de chaque élément chimique. Ensuite, ces valeurs intermédiaires sont modifiées de manière itérative par injections dans des fonctions adaptées de sorte à obtenir des valeurs intermédiaires correspondantes modifiées. Lorsque la variation des valeurs intermédiaires entre deux itérations successives est inférieure à un seuil prédéterminé, par exemple inférieur à une variation de 0,1%, alors on considère que les valeurs réelles d'épaisseur massique de l'objet et de concentration des éléments chimiques correspondants sont atteintes.

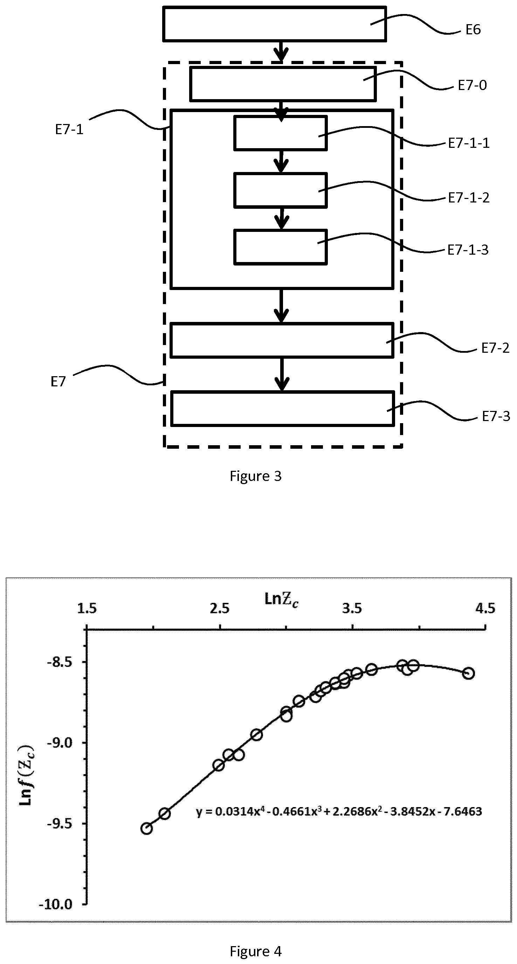

De manière plus détaillée, le procédé d'étude peut comporter une étape d'initialisation E6 (figure 3) dans laquelle une valeur intermédiaire de l'épaisseur massique $\rho z_0$, avec $\rho$ la densité supposée et $z_0$ l'épaisseur supposée de l'objet 2 au niveau de ladite zone Z1, et une valeur intermédiaire de concentration $C_{ic}$ de chaque élément chimique identifié sont déterminées par choix. Cette étape E6 est généralement réalisée entre l'étape E3 et l'étape E4.

De préférence, ledit choix pour chaque élément chimique identifié de la valeur intermédiaire de concentration $C_{ic}$ est réalisé en considérant que l'intensité du rayonnement X émergent $I_{iec}$ correspondant est égale à l'intensité du rayonnement $I_{igc}$ généré dans l'objet 2 par ledit élément chimique correspondant. La valeur intermédiaire de l'épaisseur massique $\rho z_0$ peut alors aussi être déterminée en fonction de cette considération.

Plus particulièrement, pour calculer une épaisseur massique $\rho z_0$ il sera utilisé par la suite, un terme général de correction d'incidence $\overline{\Theta}$ et pour chaque élément chimique identifié, un terme de correction d'incidence $\overline{\Theta_{im}}$ dudit élément chimique correspondant, un terme de correction de numéro atomique $\overline{\varphi_i}$ dudit élément chimique correspondant et un terme de correction d'absorption $\overline{\chi_i}$ dudit élément chimique correspondant.

Ainsi, en référence à ce qui a été dit ci-dessus, le choix peut poser comme condition initiale que le terme général de correction d'incidence $\overline{\Theta}$ (calculé pour le composé, c'est-à-dire la zone de l'objet), et les termes $\overline{\varphi_i}$ et $\overline{\chi_i}$ de correction du numéro atomique et d'absorption pour chaque constituant i sont égaux à 1. Dans ce cas on a pour valeur intermédiaire choisie de l'épaisseur massique $\rho z_0$ :

$$\rho z_0 = cos\theta \sum_{i=1}^{N} \xi_i I_{iec} \qquad \text{(éq. 1)}$$

Avec $\xi_i$ le zêta-facteur associé audit élément chimique correspondant, et $I_{iec}$ l'intensité mesurée du rayonnement X émergent dudit élément chimique correspondant.

Dans la présente description, le zêta-facteur $\xi_i$ est avantageusement celui tel que défini par Watanabe M. et Williams D.B. (2006) dans « The quantitative analysis of thin specimens : a review of progress from the Cliff-Lorimer to the new ξ-factor methods, Journal of Microscopy », vol. 221, p. 89-109, 2006. Le zêta-facteur $\xi_i$ étant notamment déterminé à partir d'une lame totalement transparente ($\overline{\varphi_i}$ = 1) composée exclusivement de l'élément chimique correspondant pur de la manière suivante :

$$\xi_i = \lim_{\rho z_0 \to 0} \frac{\rho z_0}{I_{igp}} \qquad \text{(éq. 2)}$$

Avec $I_{igp}$ l'intensité du rayonnement X généré par l'élément chimique pur correspondant par exemple mesurée expérimentalement ou simulée au moyen d'un modèle statistique de type Monte-Carlo.

Et on a pour valeur intermédiaire choisie de concentration $C_{ic}$ de l'élément chimique i :

$$C_{ic} = \frac{\xi_i}{\rho z_0} I_{iec} cos\theta \qquad \text{(éq. 3)}$$

avec $\rho z_0$ obtenu à partir de l'équation (éq. 1).

Après le choix idoine des valeurs intermédiaires de concentration $C_{ic}$ et de l'épaisseur massique $\rho z_0$ au cours de l'étape d'initialisation E6, le procédé d'étude comporte un cycle itératif d'étapes E7 comportant, pour chaque itération dudit cycle E7 une étape E7-0 de calcul du terme de correction d'incidence $\overline{\Theta}$ destiné à la prise en compte de l'angle d'incidence θ du faisceau d'électron et associé à la zone Z1 étudiée. Le cycle comporte en outre, pour chaque itération une étape d'ajustement E7-1, mise en oeuvre pour chaque élément chimique identifié. Cette étape d'ajustement E7-1 comprenant une étape de calcul E7-1-1 d'un terme de correction d'incidence $\overline{\Theta_{im}}$ associé audit élément chimique identifié et destiné à la prise en compte de l'angle d'incidence θ du faisceau d'électrons 1.

Dans la suite, lorsque l'on parle d'un terme calculé au cours dudit cycle, on parle de celui calculé au cours de l'itération courante dudit cycle.

Selon un exemple particulier, les étapes de calcul des deux termes de correction d'incidence $\overline{\Theta}$ et $\overline{\Theta_{im}}$ comprennent respectivement la résolution des équations suivantes :

-

$$\overline{\Theta} =$$

$$\left\{1 + \left[\frac{\rho z_0}{cos\theta}f(Z_c) - 2\frac{cos\theta}{\rho}\left(1 - e^{14(1-\rho)\frac{\rho z_0}{cos\theta}f(Z_c)}\right)e^{-2\frac{\rho z_0}{cos\theta}f(Z_c)}\right]\left[\frac{1}{cos\theta} - 1\right]\right\}^{0.6} \quad \text{(éq. 4) pour l'étape E7-0}$$

-

$$\overline{\Theta}_{im} = \left\{1 + \left[\frac{\rho z_{im}}{cos\theta}f_m(E_{is}) - 2\frac{cos\theta}{\rho}e^{-2\frac{\rho z_{im}}{cos\theta}f_m(E_{is})}\right]\left[\frac{1}{cos\theta} - 1\right]\right\}^{0.6} \quad \text{(éq.5)}$$

pour chaque étape E7-1-1

avec $Z_c$ le numéro atomique moyen de l'objet au niveau de ladite zone, $f(Z_c)$ une fonction du numéro atomique moyen $Z_c$, $z_{im}$ la profondeur maximale d'ionisation de l'élément chimique correspondant, $f_m(E_{is})$ une fonction de l'énergie seuil d'ionisation $E_{is}$ du niveau d'énergie considéré d'un élément chimique identifié correspondant. Bien entendu, il est clair que dans les équations (éq. 4) et (éq.5) la valeur intermédiaire de l'épaisseur massique $\rho z_0$ est celle au moment où le cycle d'étape correspondant est initié (que cela soit celle choisie dans le cadre de la première itération ou celle modifiée lors des itérations successives).

Plus particulièrement, $z_{im}$ est déterminé de manière connue par l'homme du métier, notamment en appliquant :

$$z_{im} = \frac{64(E_0^{1.68} - E_{is}^{1.68})}{\rho} \quad \text{(éq. 6)}$$

Avec $E_{is}$ l'énergie seuil d'ionisation du niveau d'énergie considéré pour ledit élément chimique correspondant (en keV).

Selon une réalisation particulière, on a :

$$f(Z_c) = e^{a(LnZ_c)^4 + b(LnZ_c)^3 + c(LnZ_c)^2 + dLnZ_c + e} \quad \text{(éq. 7)}$$

avec a, b, c, d, e des paramètres déterminés par simulation de Monte-Carlo et dépendant de l'énergie des électrons du faisceau d'électrons. En particulier, la figure 4 illustre un exemple de détermination des paramètres de la fonction $f(Z_c)$ par simulation de Monte-Carlo pour une énergie $E_0$ de 30kV. Ainsi, connaissant $E_0$, il est facile de remonter aux paramètres a, b, c, d qui dans l'exemple de 30kV sont respectivement égaux à 0,0314, -0,4661, 2,2686, -3,8452 e -7,6463.

Selon une réalisation particulière, on a

$$f_m(E_{is}) = \frac{AE_{is}^m}{(R_p/S_p)_i} \quad \text{(éq. 8)}$$

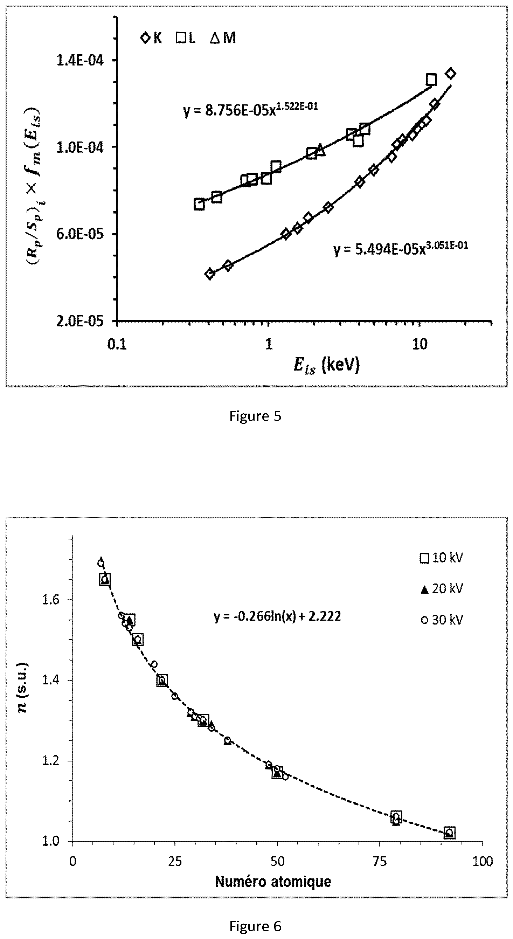

avec $(R_p/S_p)_i$ le rapport des coefficients de rétrodiffusion $R_p$ et du pouvoir d'arrêt $S_p$ pour l'élément chimique pur correspondant, et A et m des paramètres déterminés par simulation de Monte-Carlo et dépendant du niveau d'énergie considéré pour ledit élément chimique correspondant (le niveau d'énergie correspond aux couches électroniques de l'atome excité par le faisceau d'électrons). Et avec comme vu précédemment $E_{is}$ l'énergie seuil d'ionisation du niveau d'énergie considéré. La figure 5 donne un exemple de détermination des paramètres de la fonction $f_m(E_{is})$ par simulation de Monte-Carlo, les paramètres de la fonction dépendante du niveau d'énergie considéré et fonction des couches électroniques K, L ou M excitées par le faisceau d'électrons.

Il est à noter que dans la présente description, si au moment d'un calcul $z_0 \geq z_{im}$, alors l'épaisseur $z_0$ est modifiée de telle sorte à ce qu'elle soit égale à $z_{im}$ avant d'être utilisée dans le calcul.

En revenant à l'étape d'ajustement E7-1, cette dernière comporte une étape de calcul E7-1-2 du terme de correction de numéro atomique $\overline{\varphi}_i$ dudit élément chimique correspondant. Notamment, cette étape de calcul utilise les deux termes, calculés au cours dudit cycle, de correction d'incidence $\overline{\Theta}$ et $\overline{\Theta_{im}}$ décrits ci-dessus, ces termes calculés étant ceux appartenant audit cycle d'étape en cours, autrement dit l'étape E7-1-2 est réalisée après l'étape E7-1-1.

Selon une mise en oeuvre particulière, chaque étape de calcul du terme de correction de numéro atomique $\overline{\varphi_i}$ utilise la relation suivante :

$$\overline{\varphi}_i(\rho z_\theta) = \frac{1 + \alpha(\rho z_\theta)^n}{1 + \frac{\alpha\, C_{ic}}{\xi_i\, I_{igco}} \frac{(\rho z_\theta)^{(1+n)}}{(1 + \frac{\beta_i}{(\rho z_\theta)^n})}} \qquad \text{(éq. 9)}$$

avec $I_{igco}$ l'intensité par unité de temps d'un rayonnement X généré par l'élément chimique correspondant dans l'objet considéré comme opaque audit faisceau d'électron 1, $\xi_i$ le zêta-facteur associé audit élément chimique correspondant, $n$ un paramètre dépendant du numéro atomique moyen Zc de l'objet au niveau de ladite zone Z1, $\alpha$ un paramètre dépendant du numéro atomique moyen Zc de l'objet au niveau de ladite zone Z1, $\beta_i$ un terme permettant d'ajuster le maxima du terme $\overline{\varphi}_i$ et $z_\theta$ l'épaisseur selon la direction d'incidence $\theta$ déterminée à partir des termes de correction d'incidence $\overline{\Theta}$ et $\overline{\Theta_{im}}$, calculés au cours dudit cycle (lors des étapes E7-0 et E7-1-1 mises en oeuvre avant cette étape E7-1-2), notamment de la manière telle qu'indiquée ci-dessus en utilisant les équations (eq. 4) à (eq. 8) ci-dessus.

En particulier, le paramètre $n$ est déterminé par la relation suivante :

$$n = n_1 Ln Z_c + n_2 \qquad \text{(éq. 10)}$$

avec les paramètres $n_1$ et $n_2$ donnés par un abaque donnant la valeur de $n$ en fonction de $Z_c$ quelle que soit la puissance du faisceau d'électrons. La figure 6 montre justement la variation du paramètre $n$ en fonction du numéro atomique moyen $Z_c$ et ce pour différentes puissances du faisceau d'électrons connues. En particulier, il a pu être déduit de cette figure 6 que $n_1$ était préférentiellement égal à -0,266 et $n_2$ était préférentiellement égal à 2,222 en ce sens, l'application du logarithme népérien à la valeur correspondante du numéro atomique moyen peut être suffisante pour résoudre l'équation (éq. 10). il a été précisé ci-dessus que le paramètre $\alpha$ était fonction du numéro atomique moyen $Z_c$, en particulier le paramètre $\alpha$ est déterminé par la relation suivante :

$$\alpha = e^{\left(\alpha_1 (Ln Z_c)^2 + \alpha_2 Ln Z_c + \alpha_3\right)} \qquad \text{(éq. 11)}$$

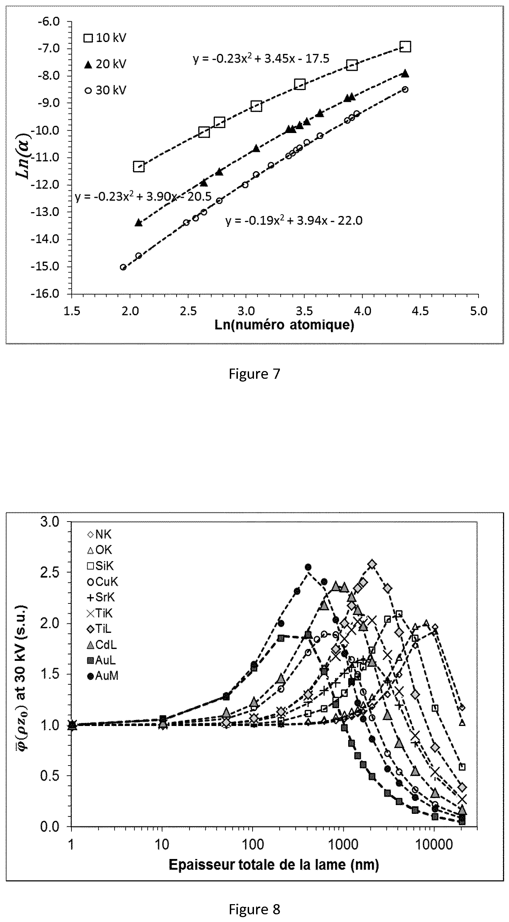

avec $\alpha_1$, $\alpha_2$ et $\alpha_3$ des paramètres dépendant de l'énergie initiale $E_0$ des électrons du faisceau d'électrons. La figure 7 illustre la variation du paramètre $\alpha$ en fonction du numéro atomique moyen $Z_c$ pour différentes puissances connues du faisceau d'électrons (ici 10kV, 20kV et 30kV).

On comprend que les paramètres $n$ et $\alpha$ ont été définis empiriquement par ajustement du terme $\overline{\varphi}_i$ calculé avec l'équation (éq. 9) aux valeurs déduites des simulations pour l'ensemble des éléments chimiques purs et objets étudiés. Par exemple, la simulation du terme $\overline{\varphi}_i$ de correction de numéro atomique pour différentes compositions et épaisseurs de lame à 30 kV est illustré en figure 8. Sur cette figure 8, les points de données sont calculés en utilisant les intensités du rayonnement X généré par simulation de Monte-Carlo et les courbes en pointillées sont calculées et ajustées aux points de données en optimisant les paramètres $n$ et $\alpha$.

Le terme $\beta_i$ est déterminé en posant que, pour toute épaisseur supérieure ou égale à une profondeur maximale d'ionisation $z_{im}$ de l'élément chimique correspondant, l'intensité du rayonnement X généré dans l'objet 2 est équivalente à celle de l'objet 2 si ce dernier est opaque audit faisceau d'électrons. Le terme $\beta_i$ est alors donné par l'équation suivante :

$$\beta_i = \begin{cases} (\rho z_{im})^n \dfrac{\left(\frac{\xi_i}{C_{ic}} \frac{I_{igco}}{\rho z_{im}} - 1\right)}{\alpha(\rho z_{im})^n - \left(\frac{\xi_i}{C_{ic}} \frac{I_{igco}}{\rho z_{im}} - 1\right)}, & si\ \beta_i > 0 \\[4mm] 0, & si\ \beta_i \le 0 \end{cases} \qquad \text{(éq. 12)}$$

Les paramètres utilisés dans le calcul de $\beta_i$ étant ceux définis précédemment et notamment au cours dudit cycle d'étapes en cours.

Le terme $\beta_i$, bien qu'avantageux, peut être négligé ($\beta_i=0$) lorsque l'épaisseur $z_0$ de l'objet 2 est au moins deux fois plus faible qu'une épaisseur $\overline{z}_i$ (définie ci-après) pour laquelle le terme de correction de numéro atomique $\overline{\varphi}_i$ est

maximum.

L'épaisseur $\bar{z}_i$ est alors calculée en résolvant l'équation suivante, notamment par calcul itératif :

$$(\rho\bar{z}_i)^{1+n} = \frac{n\xi_i l_{igco}(1+\beta_i/(\rho\bar{z}_i)^n)^2 - \rho\bar{z}_i[1+n+(1+2n)\beta_i/(\rho\bar{z}_i)^n]}{\alpha[1+(1+n)\beta_i/(\rho\bar{z}_i)^n]} \quad \text{(éq. 13)}$$

Avec n, $\alpha$ et $\beta_i$ définis par les relations (éq. 10), (éq. 11) et (éq. 12) respectivement

Selon une réalisation particulière, le terme $\bar{z}_i$ peut être calculé par l'équation suivante :

$$\bar{z}_i = \bar{z}_{ip} \frac{\rho_i}{\rho} \frac{n}{n_i} \left[1 + 0.048 \left(2.5 - \frac{E_0}{20}\right)\left(1 - LnM_i + \frac{(LnM_i)^2}{3}\right)\left(\frac{M_c}{M_i} - 1\right)\right] \quad \text{(éq. 14)}$$

avec $\bar{z}_{ip}$ l'épaisseur pour laquelle le terme de correction de numéro atomique $\bar{\varphi}_i$ de l'élément chimique pur correspondant est maximum, $n$ et $n_i$ les paramètres dépendant respectivement du numéro atomique moyen de l'objet et du numéro atomique de l'élément pur correspondant notamment tel que défini à l'équation (éq.10) ci-dessus ($n_i$ peut être calculé avec l'équation 10 en remplaçant Zc par Zi de l'élément chimique pur), $\rho$ et $\rho_i$ les densités respectivement de l'objet et de l'élément chimique pur correspondant et $M_c$ et $M_i$ les masses atomiques de l'objet et de l'élément chimique pur correspondant.

Bien que l'équation 14 donne une valeur approchée, elle sera préférée à l'équation 13 qui donne le résultat juste, car moins gourmande en ressources de calcul.

L'épaisseur $\bar{z}_{ip}$ de l'élément chimique pur correspondant est calculée en résolvant l'équation 13. Ceci peut être fait en amont une seule fois pour chaque élément chimique de telle sorte que le procédé utilise une lecture de $\bar{z}_{ip}$ dans une table dont l'entrée est l'élément chimique identifié.

Concernant l'épaisseur $z_\theta$ qui correspond à l'épaisseur traversée par le faisceau d'électrons selon la direction d'incidence $\theta$, elle peut être déduite à partir des deux termes de correction d'incidence $\overline{\varTheta}$ et $\overline{\varTheta_{im}}$, en posant notamment les équations suivantes :

$$z_\theta = Min\left(\frac{z_0}{\overline{\varTheta}cos\theta}, z_{i\theta}\right) \quad \text{(éq. 15)}$$

$$z_{i\theta} = \frac{z_{im}}{\overline{\varTheta}_{im}cos\theta} \quad \text{(éq. 16)}$$

Avec $z_\theta$ l'épaisseur selon la direction d'incidence $\theta$ prenant en compte l'angle d'incidence $\theta$ et $z_{i\theta}$ l'épaisseur maximum d'ionisation de l'élément chimique correspondant selon la direction d'incidence $\theta$.

En outre, l'étape d'ajustement E7-1 comporte une étape de calcul E7-1-3 d'un terme de correction d'absorption $\overline{\chi_i}$ dudit élément chimique correspondant. Ce terme de correction d'absorption $\overline{\chi_i}$ a pour vocation de prendre en compte l'absorption par l'objet du rayonnement X généré par l'élément chimique correspondant. Autrement dit, le terme de correction d'absorption $\overline{\chi_i}$ permet de corriger l'influence de l'objet sur le rayonnement X généré. En particulier, le calcul du terme de correction d'absorption $\overline{\chi_i}$ dudit élément chimique correspondant utilise les termes, calculés au cours dudit cycle, de correction d'incidence $\overline{\varTheta}$ et $\overline{\varTheta_{im}}$, ainsi que le terme, calculé au cours dudit cycle, de correction de numéro atomique $\overline{\varphi}_i$ (on comprend que l'étape E7-1-3 est alors mise en oeuvre après l'étape E7-1-1, l'étape E7-1-2 et l'étape E7-0).

Selon un mode de réalisation particulier, chaque étape de calcul du terme de correction d'absorption $\overline{\chi_i}$ utilise la résolution de l'équation

$$\bar{\chi}_i =$$

$$\begin{cases} \dfrac{\chi_{ic}\rho z_0 \bar{\varphi}_i(\rho z_\theta)}{\varphi_i(0)+\frac{P_i}{\chi_{ic}}+\left\{P_i'\left(\frac{1}{\chi_{ic}}-\rho z_0\right)-\left[\varphi_i(0)-\varphi_i(\rho z_0)+\frac{P_i}{\chi_{ic}}\right]+(P_i'-P_i)\rho z_{ib}\right\}e^{-\chi_{ic}\rho z_{ib}}-\left[\varphi_i(\rho z_0)+\frac{P_i'}{\chi_{ic}}\right]e^{-\chi_{ic}\rho z_0}} & , \text{ si } z_{ib} > 0 \\[2em] \dfrac{\rho z_0 \chi_{ic}\bar{\varphi}_i(\rho z_\theta)}{\varphi_i(0)+\frac{P_i''}{\chi_{ic}}-\left\{P_i''\left(\frac{1}{\chi_{ic}}+\rho z_0\right)+\varphi_i(0)\right\}e^{-\chi_{ic}\rho z_0}}, & \text{ si } z_{ib} \leq 0 \end{cases}$$

(éq. 17)

Avec $\varphi_i(0)$ la valeur de la distribution $\varphi_i(\rho z)$ des intensités du rayonnement X généré en surface de l'objet par l'élément chimique correspondant, avec z dans $\varphi_i(\rho z)$ variant de 0 à $z_0$, $\varphi_i(\rho z_0)$ la valeur de la distribution $\varphi_i(\rho z)$ des intensités du rayonnement X généré à la profondeur $z_0$ de l'objet par l'élément chimique correspondant (aussi appelé terme d'ionisation à la profondeur $z_0$), $P_i$ la pente initiale de la distribution $\varphi_i(\rho z)$ des intensités du rayonnement X généré en surface de l'objet par l'élément chimique correspondant et déterminé de la manière suivante :

$$P_i = \frac{g.h^4.(F/\bar{R})^2}{\bar{\varphi}_i(\rho z_{i\theta})\rho z_{i\theta}}\frac{1}{(cos\theta)^4} \qquad (\text{éq 18})$$

Avec $\bar{\varphi}_i(\rho z_{i\theta})$ calculé par l'eq 9 en remplaçant $z_\theta$ par $z_{i\theta}$, $z_{i\theta}$ déterminé par l'équation 16 et g, h et $(F/\bar{R})$ des paramètres connus de l'homme du métier, notamment déterminé selon la publication de Pouchou J.L. et Pichoir F. (1991) en page 40 « Quantitative analysis of homogeneous or stratified microvolumes applying the model PAP, Electron Probe Quantitation, In : Heinrich & Newbury (Eds) Plenum Press, New York, p.31 »

En particulier, en reprenant les termes de la présente description, on a :

$$g = 0.22\left(1 - 2e^{-\frac{Z_c}{15}\left(\frac{E_0}{E_{is}}-1\right)}\right)\ln(4Z_c) \quad (\text{éq. 18a})$$

$$h = 1 - 10\frac{1-\frac{1}{1+\frac{E_0}{10E_{is}}}}{Z_c^{~2}} \quad (\text{éq. 18b})$$

$$F/\bar{R} = 1 + \frac{[1+1.3\ln(Z_c)]ln[1+\left(0.2+\frac{Z_c}{200}\right)\left(1-\left\{\frac{E_{is}}{E_0}\right\}^{0.42}\right)]}{\ln(1+0.2+\frac{Z_c}{200})} \quad (\text{éq. 18c})$$

$\chi_{ic}$ est le coefficient d'absorption massique du composé pour le rayonnement X caractéristique de l'élément chimique correspondant :

$$\chi_{ic} = cosec(\psi + \theta)\sum_{i=1}^{N}C_{ic}\left(\mu/\rho\right)_i^{ip} \quad (\text{éq 19})$$

Avec $\psi$ l'angle d'élévation du détecteur X par rapport à la normale, $\theta$ l'angle d'incidence du faisceau d'électrons, $C_{ic}$ la concentration de l'élément chimique et $\left(\mu/\rho\right)_i^{ip}$ le coefficient d'absorption massique de l'élément chimique pur.

En outre, $\bar{\varphi}_i(\rho z_\theta)$ est le terme de correction de numéro atomique défini par l'eq.9 et calculé au cours dudit cycle.

Toujours dans le cadre de l'équation 17, on a :

$$P_i' = \frac{[\varphi_i(0)-\varphi_i(\rho z_0)]^2+2P_i\rho z_0[\bar{\varphi}_i(\rho z_\theta)-\varphi_i(\rho z_0)]}{\rho z_0[2\bar{\varphi}_i(\rho z_\theta)-2\varphi_i(0)-P_i\rho z_0]} \text{ (éq. 20),}$$

$$P_i'' = 2\frac{\overline{\varphi}_i(\rho z_\theta) - \varphi_i(0)}{\rho z_0} \text{ (eq.21),}$$

et

$$z_{ib} = z_0 \frac{2\overline{\varphi}_i(\rho z_\theta) - \varphi_i(0) - \varphi_i(\rho z_0)}{P_i \rho z_0 + \varphi_i(0) - \varphi_i(\rho z_0)} \text{ (éq. 22).}$$

En particulier, $z_\theta$ est obtenu selon les équations 15 et 16 dépendantes des termes de correction d'incidence calculés au cours dudit cycle.

Dans le cadre de l'équation éq. 17 permettant de calculer le terme de correction d'absorption $\overline{\chi_i}$, le paramètre $\varphi_i(0)$ peut être calculé de la manière suivante :

$$\varphi_i(0) = \begin{cases} 1 + [\varphi_{im}(0) - 1]\frac{z_0}{\overline{z}_i}, & si \quad z_0 < \overline{z}_i \\ \varphi_{im}(0), & si \quad z_0 \geq \overline{z}_i \end{cases} \text{ (éq. 23)}$$

avec $\overline{z}_i$ tel que défini par les équations éq. 13 ou 14 et $\varphi_{im}(0)$ l'ionisation de surface de l'élément chimique correspondant dans l'objet considéré comme opaque audit faisceau d'électrons déterminée de manière connue de l'homme du métier, notamment déterminée selon la publication de Pouchou J.L. et Pichoir F. (1991) Quantitative analysis of homogeneous or stratified microvolumes applying the model PAP, Electron Probe Quantitation, In : Heinrich & Newbury (Eds) Plenum Press, New York, p.31 en tant que terme d'ionisation de surface.

Selon une mise en oeuvre particulière de l'étape de calcul du terme de correction de l'absorption permettant d'optimiser la valeur calculée, l'étape de calcul comporte une étape de détermination d'un paramètre $\overline{z}_{i\theta}$ correspondant à la valeur minimum entre $\overline{z}_i$ défini par les équations eq.13 ou eq. 14 et $z_{i\theta}$ défini par l'équation eq. 16 et défini par la relation :

$$\overline{z}_{i\theta} = Min(\overline{z}_i, z_{i\theta}) \quad \text{(éq 24)}$$

Le terme $\varphi_i(\rho z_0)$ est déterminé de la manière suivante :

$$\varphi_i(\rho z_0) = \begin{cases} \left\{\left[\frac{3}{2} - \varphi_i(0)\right]\frac{z_0}{\overline{z}_{i\theta}}\left[2 - \frac{z_0}{\overline{z}_{i\theta}}\right] + \varphi_i(0)\right\}cos\theta, & si \quad z_0 < \overline{z}_{i\theta} \\ \frac{3}{2}\left\{\left[\frac{z_0 - \overline{z}_{i\theta}}{z_{im} - \overline{z}_{i\theta}}\right]\left[\frac{z_0 - \overline{z}_{i\theta}}{z_{im} - \overline{z}_{i\theta}} - 2\right] + 1\right\}cos\theta, & si \quad \overline{z}_{i\theta} \leq z_0 \leq z_{im} \\ 0 & si \quad z_0 > z_{im} \end{cases}$$

$$\text{(éq. 25)}$$

avec $\varphi_i(0)$ calculé selon l'équation (eq. 23).

Selon une alternative, il est possible de simplifier les calculs des termes de correction de numéro atomique et de correction d'absorption dans le cas particulier d'une lame perpendiculaire à l'axe du faisceau. Dans ce cas, l'angle d'incidence $\theta$ est nul ce qui a pour conséquence que les deux termes de correction d'incidence $\overline{\Theta}$ et $\overline{\Theta}_{im}$ sont égaux à 1 de telle sorte que le terme de correction de numéro atomique $\overline{\varphi}_i$ est déterminé selon l'équation suivante :

$$\overline{\varphi}_i(\rho z_0) = \frac{1 + \alpha(\rho z_0)^n}{1 + \frac{\alpha\,C_{ic}}{\xi_i\,l_{igco}}\frac{(\rho z_0)^{(1+n)}}{(1 + \frac{\beta_i}{(\rho z_0)^n})}} \quad \text{(éq. 26)}$$

Les paramètres de $\overline{\varphi}_i(\rho z_0)$ dans le cadre de cette alternative sont tels que déjà décrits. Toujours dans le cadre de cette alternative, le terme de correction d'absorption peut être calculé par résolution de l'équation (éq. 17) avec l'utilisation des équations (éq. 20), (éq. 21), (éq.22), en remplaçant dans ces équations $\overline{\rho}_i(\rho z_\theta)$ par $\overline{\varphi}_i(\rho z_0)$, avec $P_i$ la pente initiale de la distribution $\varphi_i(\rho z)$ - z variant ici de 0 à $z_0$- des intensités du rayonnement X généré en surface de l'objet par l'élément chimique correspondant et déterminée de la manière suivante :

$$P_i = \frac{g.h^4.(F/\overline{R})^2}{\overline{\varphi}_i(\rho z_{im})\rho z_{im}} \qquad (\text{éq } 27)$$

Avec $\overline{\varphi}_i(\rho z_{im})$ calculé par l'éq 26 en remplaçant $z_0$ par $z_{im}$, $z_{im}$ déterminé par l'équation 6 et g, h et $(F/\overline{R})$ des paramètres connus, notamment déterminés selon la publication de Pouchou J.L. et Pichoir F. (1991) Quantitative analysis of homogeneous or stratified microvolumes applying the model PAP, Electron Probe Quantitation, In : Heinrich & Newbury (Eds) Plenum Press, New York, p.31

$\chi_{ic}$ le coefficient d'absorption massique du rayonnement X caractéristique de l'élément chimique correspondant :

$$\chi_{ic} = cosec(\psi) \sum_{i=1}^{N} C_{ic} \left(\mu/\rho\right)_i^{ip} \quad \text{eq } 28$$

Dans le cadre de l'angle d'incidence nul ; le terme $\varphi_i(\rho z_0)$ est déterminé de la manière suivante :

$$\varphi_i(\rho z_0) = \begin{cases} \left[\frac{3}{2} - \varphi_i(0)\right]\frac{z_0}{\overline{z}_i}\left[2 - \frac{z_0}{\overline{z}_i}\right] + \varphi_i(0), & si \quad z_0 < \overline{z}_i \\ \frac{3}{2}\left\{\left[\frac{z_0 - \overline{z}_i}{z_{im} - \overline{z}_i}\right]\left[\frac{z_0 - \overline{z}_i}{z_{im} - \overline{z}_i} - 2\right] + 1\right\}, & si \quad \overline{z}_i \le z_0 \le z_{im} \\ 0 & si \quad z_0 > z_{im} \end{cases} \qquad (\text{éq.} \quad 29),$$

$\varphi_i(0)$ défini par l'éq.23, $\overline{z}_i$ défini selon les équations 13 ou 14.

On a vu précédemment différentes façons de calculer les termes de correction de numéro atomique et de correction d'absorption.

Une fois ces termes calculés, ledit cycle d'étapes E7 comporte une étape de modification E7-2 de la valeur intermédiaire d'épaisseur massique $\rho z_0$ utilisant le terme, calculé au cours dudit cycle, de correction d'incidence $\overline{\Theta}$, et les termes de correction d'incidence $\overline{\Theta}_{im}$, de correction de numéro atomique $\overline{\varphi}_i$ et de correction d'absorption $\overline{\chi}_i$ calculés au cours dudit cycle pour chaque élément chimique et fonction de chaque étape de mesure E3.

En particulier, la valeur intermédiaire d'épaisseur massique peut être déterminée selon la formulation suivante :

$$\rho z_0 = \overline{\Theta} \ cos\theta \sum_{i=1}^{N} \xi_i \frac{I_{igc}}{\overline{\varphi}_i} \ (\text{éq. } 30)$$

Avec l'application de la formulation suivante pour l'intensité du rayonnement X généré par l'élément chimique i dans l'objet $I_{igc}$ :

$$I_{igc} = \overline{\chi}_i I_{iec} \ (\text{éq. } 31)$$

Dans ces formules, on entend bien que pour chaque cycle E7 ce sont les valeurs calculées au cours dudit cycle E7 des termes de correction d'incidence, de correction de numéro atomique et de correction d'absorption qui sont utilisés pour modifier au cours du même cycle les valeurs intermédiaires d'épaisseur massique et de concentration.

En outre, ledit cycle d'étapes E7 comporte une étape de modification E7-3, pour chaque élément chimique, de la valeur intermédiaire de concentration $C_{ic}$ dudit élément chimique correspondant utilisant la valeur intermédiaire d'épaisseur massique $\rho z_0$ telle que modifiée au cours dudit cycle, le terme, calculé au cours dudit cycle de correction d'incidence $\overline{\Theta}$, et les termes de correction d'incidence $\overline{\Theta}_{im}$, de correction de numéro atomique $\overline{\varphi}_i$ et de correction d'absorption $\overline{\chi}_i$ calculés au cours dudit cycle et correspondant audit élément chimique.

Autrement dit, au cours de chaque cycle E7 la valeur intermédiaire de l'épaisseur massique est modifiée (étape E7-2) selon la formule suivante $\rho z_0 = \bar{\Theta} cos\theta \sum_{i=1}^{N} \xi_i \frac{\overline{\chi_i} I_{iec}}{\overline{\varphi_i}}$ (éq. 32) avec N le nombre total d'éléments chimiques identifiés, i l'index de l'élément chimique courant étudié, $I_{iec}$ l'intensité du rayonnement X émergent correspondant audit élément chimique d'index i, $\overline{\chi_i}$ le terme de correction d'absorption calculé au cours dudit cycle et correspondant audit élément chimique d'index i, $\xi_i$ le zêta-facteur associé audit élément chimique d'index i, le terme de correction de numéro atomique $\overline{\varphi_i}$ calculé au cours dudit cycle et correspondant audit élément chimique d'index i, $\overline{\Theta}$ le terme de correction d'incidence calculé au cours dudit cycle.

En particulier, pour chaque élément chimique, la valeur intermédiaire de concentration $C_{ic}$ peut être calculée (étape E7-3) en utilisant la formule suivante :

$$C_{ic} = \frac{\xi_i}{\rho z_0} \frac{I_{igc}}{\overline{\varphi_i}} \bar{\Theta} cos\theta \text{ (éq. 33)}$$

Dans laquelle $I_{igc}$ est déterminé selon l'équation (éq. 31), $\rho z_0$ correspond à la valeur d'épaisseur massique telle que modifiée au cours dudit cycle d'étapes correspondant, $\overline{\Theta}$ correspondant au terme de correction d'incidence calculé au cours dudit cycle et $\overline{\varphi_i}$ correspondant au terme de correction de numéro atomique tel que calculé au cours dudit cycle d'étapes correspondant. Autrement dit, au cours de chaque cycle la valeur intermédiaire de concentration $C_{ic}$ de chaque élément chimique est calculée selon la formule suivante : $C_{ic} = \frac{\xi_i}{\rho z_0} \frac{\overline{\chi_i} I_{iec}}{\overline{\varphi_i}} \bar{\Theta} cos\theta$ (éq. 34) avec $I_{iec}$ l'intensité mesurée du rayonnement X émergent dudit élément chimique correspondant, $\rho z_0$ la valeur intermédiaire d'épaisseur massique modifiée au cours dudit cycle, $\overline{\chi_i}$ le terme de correction d'absorption dudit élément chimique correspondant calculé au cours dudit cycle, $\xi_i$ le zêta-facteur associé audit élément chimique correspondant, $\overline{\Theta}$ le terme de correction d'incidence calculé au cours dudit cycle, le terme de correction de numéro atomique $\overline{\varphi_i}$ calculé au cours dudit cycle dudit élément chimique correspondant.

L'itération du cycle d'étape E7 est stoppée lorsque la variation, entre deux itérations successives des valeurs intermédiaires d'épaisseur massique $\rho z_0$ et des valeurs intermédiaires de concentration $C_{ic}$ de chaque élément chimique, est inférieure à un seuil prédéterminé associé, ladite valeur d'épaisseur massique intermédiaire modifiée définissant la valeur d'épaisseur massique déterminée et chaque valeur intermédiaire de concentration modifiée définissant la valeur de concentration déterminée correspondante.

Le procédé décrit ci-avant permet d'étudier une zone précise de l'objet. Selon les besoins, il peut être utile d'analyser l'objet dans sa globalité. En ce sens, l'invention est aussi relative à un procédé d'étude d'un objet comportant les étapes suivantes :

- Diviser l'objet en plusieurs zones à étudier,

- Mettre en oeuvre, pour chaque zone, ledit procédé d'étude tel que décrit précédemment en vue de déterminer la valeur d'épaisseur massique correspondante et, pour chaque élément chimique de ladite zone, la valeur de concentration correspondante.

Les procédés décrits ci-dessus permettent notamment de calculer l'épaisseur et la composition d'une lame mince semi-transparente/semi-opaque à partir d'une mesure par SDE (spectrométrie à dispersion d'énergie) dans un MEB (microscope à balayage électronique), ce qu'aucune méthode actuelle, à savoir ni la méthode des k-facteurs, ni la méthode $\varphi\rho z$, ne permet de faire. Par ailleurs, l'invention combine à la fois précision et rapidité des calculs permettant de réaliser en temps réel des profils et des cartographies fiables, à mieux que 5% dans la plupart des cas, de la répartition des épaisseurs massiques et des concentrations.

D'une façon générale, les procédés décrits ci-avant intéressent potentiellement tous les constructeurs de système SDE pour MEB dans la mesure où elle permet l'analyse simultanée de la composition et l'épaisseur massique de n'importe quel type de matériaux homogène, quelle que soit son épaisseur et sa composition. Au moins deux types de matériaux sont concernés :

- les lames minces préparées par FIB pour « Focused Ion Bean ou Faisceau d'ions focalisés » (épaisseurs variables entre 100 et 300nm) ou par toute autre technique de polissage (ultra-microtomie, polissage mécanique, chimique ou ionique),
- tout type de matériaux déposés sur grille TEM, pour « Transmission Electron Microscope ou microscope électronique à transmission en français », transparente (nanofils, nanoparticules etc...).

Une autre application concerne la caractérisation de lames minces de référence pour l'analyse quantitative SDE en microscopie électronique à transmission (MET). En effet, l'analyse quantitative par MET/SDE nécessite une calibration du spectromètre au moyen de lames minces de référence dont la composition et l'épaisseur doivent être préalablement déterminées.

**Revendications**

1.  Procédé d'étude d'une zone (Z1) d'un objet (2), ladite zone (Z1) présentant une épaisseur massique et comportant au moins un élément chimique, **caractérisé en ce qu'**il comporte :

    - une étape d'exposition (E1) d'une partie de la zone (Z1) de l'objet (2) à un faisceau d'électrons (1),
    - une étape d'identification (E2) de chaque élément chimique présent dans ladite zone (Z1) grâce à l'étape d'exposition (E1),
    - une étape de mesure (E3), pour chaque élément chimique identifié, d'une intensité correspondante d'un rayonnement X émergent de l'objet (2) du fait de ladite étape d'exposition(E1),
    - une étape de détermination (E4) d'une valeur de ladite épaisseur massique fonction de chaque étape de mesure (E3),
    - une étape de détermination (E5) d'une valeur de la concentration de chaque élément chimique identifié utilisant ladite valeur de l'épaisseur massique déterminée,

    et **en ce qu'**il comporte une étape d'initialisation (E6) dans laquelle une valeur intermédiaire de l'épaisseur massique $\rho z_0$, avec $\rho$ la densité supposée et $z_0$ l'épaisseur supposée de l'objet (2) au niveau de ladite zone (Z1), et une valeur intermédiaire de concentration $C_{ic}$ de chaque élément chimique identifié sont déterminées par choix, notamment en considérant que l'intensité du rayonnement X émergent correspondant est égale à l'intensité du rayonnement généré dans l'objet par ledit élément chimique correspondant, et **en ce qu'**il comporte un cycle (E7) itératif d'étapes comportant pour chaque itération dudit cycle (E7) :

    - une étape de calcul (E7-0) d'un terme de correction d'incidence $\overline{\Theta}$ destiné à la prise en compte de l'angle d'incidence θ du faisceau d'électrons et associé à la zone (Z1) étudiée,
    - une étape d'ajustement (E7-1), mise en oeuvre pour chaque élément chimique identifié, et comprenant :

        ◦ une étape de calcul (E7-1-1) d'un terme de correction d'incidence $\overline{\Theta_{im}}$ associé audit élément chimique identifié et destiné à la prise en compte de l'angle d'incidence θ du faisceau d'électrons (1),
        ◦ une étape de calcul (E7-1-2) d'un terme de correction de numéro atomique $\overline{\varphi_i}$ dudit élément chimique correspondant utilisant les termes calculés, au cours dudit cycle, de correction d'incidence $\overline{\Theta}$ et $\overline{\Theta_{im}}$,
        ◦ une étape de calcul (E7-1-3) d'un terme de correction d'absorption $\overline{\chi_i}$ dudit élément chimique correspondant utilisant les termes calculés, au cours dudit cycle, de correction d'incidence $\overline{\Theta}$ et $\overline{\Theta_{im}}$ et le terme calculé, au cours dudit cycle, de correction de numéro atomique $\overline{\varphi_i}$,

    - une étape de modification (E7-2) de la valeur intermédiaire d'épaisseur massique $\rho z_0$ utilisant le terme, calculé au cours dudit cycle, de correction d'incidence $\overline{\Theta}$, et les termes de correction d'incidence $\overline{\Theta_{im}}$, de correction de numéro atomique $\overline{\varphi_i}$ et de correction d'absorption $\overline{\chi_i}$ calculés au cours dudit cycle pour chaque élément chimique et fonction de chaque étape de mesure,
    - une étape de modification (E7-3), pour chaque élément chimique, de la valeur intermédiaire de concentration $C_{ic}$ dudit élément chimique correspondant utilisant la valeur intermédiaire d'épaisseur massique $\rho z_0$ telle que modifié au cours dudit cycle, le terme, calculé au cours dudit cycle, de correction d'incidence $\overline{\Theta}$ et les termes de correction d'incidence $\overline{\Theta_{im}}$, de correction de numéro atomique $\overline{\varphi_i}$ et de correction d'absorption $\overline{\chi_i}$ calculés au cours dudit cycle et correspondants audit élément chimique,

    et **en ce que** l'itération est stoppée lorsque la variation, entre deux itérations successives des valeurs intermédiaires d'épaisseur massique $\rho z_0$ et des valeurs intermédiaires de concentration $C_{ic}$ de chaque élément chimique, est inférieure à un seuil prédéterminé associé, ladite valeur d'épaisseur massique intermédiaire modifiée définissant la valeur d'épaisseur massique déterminée et chaque valeur intermédiaire de concentration modifiée définissant la valeur de concentration déterminée correspondante.

2. Procédé selon la revendication 1, **caractérisé en ce que** chaque étape de calcul (E7-0) du terme de correction d'incidence $\overline{\Theta}$ comprend la résolution de l'équation suivante :

$$\overline{\Theta} =$$

$$\left\{1 + \left[\frac{\rho z_0}{\cos\theta} f(\mathbb{Z}_c) - 2\frac{\cos\theta}{\rho}\left(1 - e^{14(1-\rho)\frac{\rho z_0}{\cos\theta}f(\mathbb{Z}_c)}\right)e^{-2\frac{\rho z_0}{\cos\theta}f(\mathbb{Z}_c)}\right]\left[\frac{1}{\cos\theta} - 1\right]\right\}^{0.6}$$

et **en ce que** chaque étape de calcul (E7-1-1) du terme de correction d'incidence $\overline{\Theta_{im}}$ comprend la résolution de l'équation suivante :

$$\overline{\Theta}_{im} = \left\{1 + \left[\frac{\rho z_{im}}{\cos\theta} f_m(E_{is}) - 2\frac{\cos\theta}{\rho}e^{-2\frac{\rho z_{im}}{\cos\theta}f_m(E_{is})}\right]\left[\frac{1}{\cos\theta} - 1\right]\right\}^{0.6}$$

avec $Z_c$ le numéro atomique moyen de l'objet au niveau de ladite zone, $f(Z_c)$ une fonction du numéro atomique moyen $Z_c$, $z_{im}$ la profondeur maximale d'ionisation de l'élément chimique correspondant, $f_m(E_{is})$ une fonction de l'énergie seuil d'ionisation $E_{is}$ du niveau d'énergie considéré d'un élément chimique correspondant.

3. Procédé selon la revendication précédente, **caractérisé en ce que** $f(Z_c) = e^{a(LnZ_C)^4+b(LnZ_C)^3+c(LnZ_C)^2+d(LnZ_C)+e}$, avec a, b, c, d, e des paramètres déterminés par simulation de Monte-Carlo et dépendant de l'énergie des électrons dudit faisceau d'électrons.

4. Procédé selon l'une des revendications 2 ou 3, **caractérisé en ce que** $f_m(E_{is}) = \dfrac{AE_{is}^m}{(R_p/S_p)_i}$ avec $(R_p/S_p)_i$ étant le rapport des coefficients de rétrodiffusion $R_p$ et du pouvoir d'arrêt $S_p$ pour l'élément chimique pur correspondant, et A et m des paramètres déterminés par simulation de Monte-Carlo et dépendant du niveau d'énergie pour ledit élément chimique correspondant.

5. Procédé selon l'une des revendications 1 à 4, **caractérisé en ce que** chaque étape de calcul (E7-1-2) du terme de correction de numéro atomique $\overline{\varphi_i}$ utilise la relation suivante $\overline{\varphi}_i(\rho z_\theta) = \dfrac{1 + \alpha(\rho z_\theta)^n}{1 + \frac{\alpha\,C_{ic}}{\xi_i\,I_{igco}}\frac{(\rho z_\theta)^{(1+n)}}{(1 + \frac{\beta_i}{(\rho z_\theta)^n})}}$ avec $I_{igco}$ l'intensité par unité de temps d'un rayonnement X généré par l'élément chimique correspondant dans l'objet considéré comme opaque audit faisceau d'électron, $\xi_i$ le zêta-facteur associé audit élément chimique correspondant, $n$ un paramètre dépendant du numéro atomique moyen Zc de l'objet au niveau de ladite zone, $\alpha$ un paramètre dépendant du numéro atomique moyen Zc de l'objet au niveau de ladite zone, $\beta_i$ un terme permettant d'ajuster le maxima du terme $\overline{\varphi_i}$ et $z_\theta$ l'épaisseur selon la direction d'incidence θ déterminée à partir des termes, calculés au cours dudit cycle, de correction d'incidence $\overline{\Theta}$ et $\overline{\Theta_{im}}$.

6. Procédé selon la revendication précédente, **caractérisé en ce que** le paramètre $n$ est déterminé par la relation suivante $n = n_1 LnZ_c + n_2$, les paramètres $n_1$ et $n_2$ étant donnés par un abaque donnant la valeur de $n$ en fonction de $Z_c$ quelle que soit la puissance du faisceau d'électrons.

7. Procédé selon l'une des revendications 5 ou 6, **caractérisé en ce que** le paramètre $\alpha$ est déterminé par la relation suivante $\alpha = e^{(\alpha_1(LnZ_C)^2+\alpha_2(LnZ_C)+\alpha_3)}$, avec $\alpha_1$, $\alpha_2$ et $\alpha_3$ des paramètres dépendant de l'énergie initiale $E_0$ des électrons du faisceau d'électrons.

8. Procédé selon l'une des revendications 5 à 7, **caractérisé en ce que** le terme $\beta_i$ est déterminé en posant que, pour toute épaisseur supérieure ou égale à une profondeur maximale d'ionisation $z_{im}$ de l'élément chimique correspondant, l'intensité du rayonnement X généré dans l'objet (2) est équivalente à celle de l'objet si ce dernier est opaque audit faisceau d'électrons.

9. Procédé selon la revendication précédente, **caractérisé en ce que** le terme $\beta_i$ est obtenu par la résolution de

l'équation suivante : $\beta_i = \begin{cases} (\rho z_{im})^n \dfrac{\left(\frac{\xi_i}{C_{ic}}\frac{I_{igco}}{\rho z_{im}}-1\right)}{\alpha(\rho z_{im})^n-\left(\frac{\xi_i}{C_{ic}}\frac{I_{igco}}{\rho z_{im}}-1\right)}, & si \ \beta_i > 0 \\ 0, & si \ \beta_i \leq 0 \end{cases}$ , avec $z_{im}$ la profondeur maximale

d'ionisation de l'élément chimique correspondant.

10. Procédé selon l'une des revendications 1 à 8, **caractérisé en ce que** chaque étape de calcul (E7-1-3) du terme de correction d'absorption $\overline{\chi_i}$ utilise la résolution de l'équation

$\bar{\chi}_i =$

$\begin{cases} \dfrac{\chi_{ic}\rho z_0\overline{\varphi}_i(\rho z_\theta)}{\varphi_i(0)+\frac{P_i}{\chi_{ic}}+\left\{P_i'\left(\frac{1}{\chi_{ic}}-\rho z_0\right)-\left[\varphi_i(0)-\varphi_i(\rho z_0)+\frac{P_i}{\chi_{ic}}\right]+(P_i'-P_i)\rho z_{ib}\right\}e^{-\chi_{ic}\rho z_{ib}}-\left[\varphi_i(\rho z_0)+\frac{P_i'}{\chi_{ic}}\right]e^{-\chi_{ic}\rho z_0}}, & si \ z_{ib} > 0 \\[4mm] \dfrac{\rho z_0\chi_{ic}\overline{\varphi}_i(\rho z_\theta)}{\varphi_i(0)+\frac{P_i''}{\chi_{ic}}-\left\{P_i''\left(\frac{1}{\chi_{ic}}+\rho z_0\right)+\varphi_i(0)\right\}e^{-\chi_{ic}\rho z_0}}, & si \ z_{ib} \leq 0 \end{cases}$

avec $\varphi_i(0)$ la valeur de la distribution des intensités du rayonnement X généré en surface de l'objet par l'élément chimique correspondant, $\varphi_i(\rho z_0)$ la valeur de la distribution des intensités du rayonnement X généré à la profondeur $z_0$ de l'objet par l'élément chimique correspondant, $P_i$ la pente initiale de la distribution des intensités du rayonnement X généré en surface de l'objet par l'élément chimique correspondant et déterminée par la relation

$P_i = \dfrac{g.h^4.(F/\bar{R})^2}{\overline{\varphi}_i(\rho z_{i\theta})\rho z_{i\theta}}\dfrac{1}{(cos\theta)^4}$, avec $\overline{\varphi}_i(\rho z_{i\theta}) = \dfrac{1+\alpha(\rho z_{i\theta})^n}{1+\frac{\alpha\,C_{ic}}{\xi_i\,I_{igco}}\frac{(\rho z_{i\theta})^{(1+n)}}{(1+\frac{\beta_i}{(\rho z_{i\theta})^n})}}$ et $z_{i\theta} = \dfrac{z_{im}}{\overline{\theta}_{im}cos\theta}$, $\chi_{ic}$ représentant le

coefficient d'absorption massique du composé pour le rayonnement X caractéristique de l'élément chimique correspondant, $\overline{\varphi}_i(\rho z_\theta)$ étant le terme de correction de numéro atomique calculé au cours dudit cycle,

$P_i' = \dfrac{[\varphi_i(0)-\varphi_i(\rho z_0)]^2+2P_i\rho z_0[\overline{\varphi}_i(\rho z_\theta)-\varphi_i(\rho z_0)]}{\rho z_0[2\overline{\varphi}_i(\rho z_\theta)-2\varphi_i(0)-P_i\rho z_0]}$, $\qquad P_i'' = 2\dfrac{\overline{\varphi}_i(\rho z_\theta)-\varphi_i(0)}{\rho z_0}$, $\qquad z_{ib} =$

$z_0\dfrac{2\overline{\varphi}_i(\rho z_\theta)-\varphi_i(0)-\varphi_i(\rho z_0)}{P_i\rho z_0+\varphi_i(0)-\varphi_i(\rho z_0)}$, $z_{im}$ la profondeur maximale d'ionisation de l'élément chimique correspondant, $\beta_i$ un terme permettant d'ajuster le maxima du terme de correction de numéro atomique, $I_{igco}$ l'intensité par unité de temps d'un rayonnement X généré par l'élément chimique correspondant dans l'objet considéré comme opaque audit faisceau d'électron, $\xi_i$ le zêta-facteur associé audit élément chimique correspondant, $\alpha$ un paramètre dépendant du numéro atomique moyen Zc de l'objet au niveau de ladite zone (Z1), n un paramètre dépendant du numéro atomique moyen Zc de l'objet au niveau de ladite zone et $z_\theta$ la profondeur de l'objet au niveau de ladite zone en tenant compte de l'incidence θ du faisceau d'électrons.

11. Procédé selon la revendication précédente, **caractérisé en ce que** le paramètre $\varphi_i(0)$ est calculé de la manière

suivante : $\qquad \varphi_i(0) = \begin{cases} 1+[\varphi_{im}(0)-1]\frac{z_0}{\overline{z}_i}, & si \ z_0 < \overline{z}_i \\ \varphi_{im}(0), & si \ z_0 \geq \overline{z}_i \end{cases}$ $\qquad$ avec $\qquad \overline{z}_i = \overline{z}_{ip}\frac{\rho_i}{\rho}\frac{n}{n_i}\Big[1+$

$0.048\left(2.5-\frac{E_0}{20}\right)\left(1-LnM_i+\frac{(LnM_i)^2}{3}\right)\left(\frac{M_c}{M_i}-1\right)\Big]$, $\varphi_{im}(0)$ l'ionisation de surface de l'élément chimique correspondant dans l'objet considéré comme opaque audit faisceau d'électron , $\overline{z}_{ip}$ l'épaisseur pour laquelle le terme de correction de numéro atomique $\bar{\varphi}_i$ de l'élément chimique pur correspondant est maximum, $n$ et $n_i$ des paramètres dépendant respectivement du nombre atomique moyen de l'objet et du nombre atomique de l'élément chimique pur, $\rho_i$ la densité de l'élément chimique pur correspondant et $M_c$ et $M_i$ les masses atomiques de l'objet et de l'élément chimique pur correspondant, et $E_0$ l'énergie initiale des électrons du faisceau d'électrons.

**12.** Procédé selon la revendication précédente **caractérisé en ce qu'**il comporte une étape de détermination d'un paramètre $\bar{z}_{i\theta}$ correspondant à la valeur minimum entre $\bar{z}_i$ et $z_{i\theta}$ et défini par la relation suivante : $\bar{z}_{i\theta} = Min(\bar{z}_i, z_{i\theta})$.

**13.** Procédé selon la revendication précédente, **caractérisé en ce que** le terme $\varphi_i(\rho z_0)$ est déterminé de la manière suivante : $\varphi_i(\rho z_0) =$

$$\begin{cases} \left\{\left[\frac{3}{2} - \varphi_i(0)\right]\frac{z_0}{\bar{z}_{i\theta}}\left[2 - \frac{z_0}{\bar{z}_{i\theta}}\right] + \varphi_i(0)\right\} cos\theta, & si \quad z_0 < \bar{z}_{i\theta} \\ \frac{3}{2}\left\{\left[\frac{z_0 - \bar{z}_{i\theta}}{z_{im} - \bar{z}_{i\theta}}\right]\left[\frac{z_0 - \bar{z}_{i\theta}}{z_{im} - \bar{z}_{i\theta}} - 2\right] + 1\right\} cos\theta, & si \quad \bar{z}_{i\theta} \leq z_0 \leq z_{im} \\ 0 & si \quad z_0 > z_{im} \end{cases}$$

**14.** Procédé selon la revendication 1, **caractérisé en ce que** l'angle d'incidence $\theta$ étant nul alors les deux termes de correction d'incidence $\bar{\Theta}$ et $\bar{\Theta}_{im}$ sont égaux à 1 de telle sorte que le terme de correction de numéro atomique est déterminé à partir de l'équation suivante $\bar{\varphi}_i(\rho z_0) = \dfrac{1 + \alpha(\rho z_0)^n}{1 + \dfrac{\alpha\, C_{ic}}{\xi_i\, I_{igco}}\dfrac{(\rho z_0)^{(1+n)}}{(1 + \dfrac{\beta_i}{(\rho z_0)^n})}}$ avec $I_{igco}$ l'intensité par unité de temps d'un rayonnement X généré par l'élément chimique correspondant dans l'objet considéré comme opaque audit faisceau d'électrons, $\xi_i$ le zêta-facteur associé audit élément chimique correspondant, $n$ un paramètre dépendant du numéro atomique moyen Zc de l'objet au niveau de ladite zone, $\alpha$ un paramètre dépendant du numéro atomique moyen Zc de l'objet au niveau de ladite zone, $\beta_i$ un terme permettant d'ajuster le maxima du terme $\bar{\varphi}_i$, et **en ce que**

$\bar{\chi}_i =$

$$\begin{cases} \dfrac{\chi_{ic}\rho z_0\bar{\varphi}_i(\rho z_0)}{\varphi_i(0) + \frac{P_i}{\chi_{ic}} + \left\{P_i'\left(\frac{1}{\chi_{ic}} - \rho z_0\right) - \left[\varphi_i(0) - \varphi_i(\rho z_0) + \frac{P_i}{\chi_{ic}}\right] + (P_i' - P_i)\rho z_{ib}\right\}e^{-\chi_{ic}\rho z_{ib}} - \left[\varphi_i(\rho z_0) + \frac{P_i'}{\chi_{ic}}\right]e^{-\chi_{ic}\rho z_0}}, & si\ z_{ib} > 0 \\[3em] \dfrac{\rho z_0\chi_{ic}\bar{\varphi}_i(\rho z_0)}{\varphi_i(0) + \frac{P_i''}{\chi_{ic}} - \left\{P_i''\left(\frac{1}{\chi_{ic}} + \rho z_0\right) + \varphi_i(0)\right\}e^{-\chi_{ic}\rho z_0}}, & si\ z_{ib} \leq 0 \end{cases}$$

avec $\varphi_i(\rho z_0) = \begin{cases} \left[\frac{3}{2} - \varphi_i(0)\right]\frac{z_0}{\bar{z}_i}\left[2 - \frac{z_0}{\bar{z}_i}\right] + \varphi_i(0), & si \quad z_0 < \bar{z}_i \\ \frac{3}{2}\left\{\left[\frac{z_0 - \bar{z}_i}{z_{im} - \bar{z}_i}\right]\left[\frac{z_0 - \bar{z}_i}{z_{im} - \bar{z}_i} - 2\right] + 1\right\}, & si\ \bar{z}_i \leq z_0 \leq z_{im} \\ 0 & si \quad z_0 > z_{im} \end{cases}$, $\varphi_i(0)$ la valeur de la distribution des intensités du rayonnement X généré en surface de l'objet par l'élément chimique correspondant, $P_i$ la pente initiale de la distribution des intensités du rayonnement X généré en surface de l'objet par l'élément chimique correspondant et déterminé par la relation $P_i = \dfrac{g.h^4.(F/\bar{R})^2}{\bar{\varphi}_i(\rho z_{im})\rho z_{im}}$ avec

$$\overline{\varphi}_i(\rho z_{im}) = \frac{1 + \alpha(\rho z_{im})^n}{1 + \frac{\alpha}{\xi_i} \frac{C_{ic}}{I_{igco}} \frac{(\rho z_{im})^{(1+n)}}{(1 + \frac{\beta_i}{(\rho z_{im})^n})}},$$

$\chi_{ic}$ représentant le coefficient d'absorption massique de l'objet pour l'élément chimique correspondant

$$P_i' = \frac{[\varphi_i(0) - \varphi_i(\rho z_0)]^2 + 2P_i\rho z_0[\overline{\varphi}_i(\rho z_0) - \varphi_i(\rho z_0)]}{\rho z_0[2\overline{\varphi}_i(\rho z_0) - 2\varphi_i(0) - P_i\rho z_0]},$$

$$P_i'' = 2\frac{\overline{\varphi}_i(\rho z_0) - \varphi_i(0)}{\rho z_0}, \text{ et } z_{ib} = z_0 \frac{2\overline{\varphi}_i(\rho z_0) - \varphi_i(0) - \varphi_i(\rho z_0)}{P_i\rho z_0 + \varphi_i(0) - \varphi_i(\rho z_0)},$$

$z_{im}$ la profondeur maximale d'ionisation de l'élément chimique correspondant,

$$\overline{z}_i = \overline{z}_{ip} \frac{\rho_i}{\rho} \frac{n}{n_i}\left[1 + 0.048\left(2.5 - \frac{E_0}{20}\right)\left(1 - LnM_i + \frac{(LnM_i)^2}{3}\right)\left(\frac{M_c}{M_i} - 1\right)\right],$$

$\overline{z}_{ip}$ l'épaisseur pour laquelle le terme de correction de numéro atomique $\overline{\varphi}_i$ de l'élément chimique pur correspondant est maximum, $n$ et $n_i$ des paramètres dépendant respectivement du numéro atomique moyen de l'objet et du numéro atomique de l'élément pur correspondant, $\rho_i$ la densité de l'élément chimique pur correspondant et $M_c$ et $M_i$ les masses atomiques de l'objet et de l'élément chimique pur correspondant, $E_o$ l'énergie initiale des électrons du faisceau d'électrons, $\beta_i$ un terme permettant d'ajuster le maxima du terme de correction de numéro atomique, $I_{igco}$ l'intensité par unité de temps d'un rayonnement X généré par l'élément chimique correspondant dans l'objet considéré comme opaque audit faisceau d'électron, $\xi_i$ le zêta-facteur associé audit élément chimique correspondant, $\alpha$ un paramètre dépendant du numéro atomique moyen Zc de l'objet au niveau de ladite zone (Z1), $n$ un paramètre dépendant du numéro atomique moyen Zc de l'objet au niveau de ladite zone.

**15.** Procédé selon l'une quelconque des revendications 1 à 14, **caractérisé en ce qu'**au cours de chaque cycle (E7) la valeur intermédiaire de l'épaisseur massique est modifiée selon la formule suivante

$$\rho z_0 = \overline{\Theta} \cos\theta \sum_{i=1}^{N} \xi_i \frac{\overline{\chi}_i I_{iec}}{\overline{\varphi}_i}$$

avec N le nombre total d'éléments chimiques identifiés, i l'index de l'élément chimique courant étudié, $I_{iec}$ l'intensité du rayonnement X émergent correspondant audit élément chimique d'index i, $\overline{\chi}_i$ le terme de correction d'absorption calculé au cours dudit cycle et correspondant audit élément chimique d'index i, $\xi_i$ le zêta-facteur associé audit élément chimique d'index i, le terme de correction de numéro atomique $\overline{\varphi}_i$ calculé au cours dudit cycle et correspondant audit élément chimique d'index i, $\overline{\Theta}$ le terme de correction d'incidence calculé au cours dudit cycle

**16.** Procédé selon l'une quelconque des revendications 1 à 15, **caractérisé en ce qu'**au cours de chaque cycle la valeur intermédiaire de concentration $C_{ic}$ de chaque élément chimique est calculée selon la formule suivante :

$$C_{ic} = \frac{\xi_i}{\rho z_0} \frac{\overline{\chi}_i I_{iec}}{\overline{\varphi}_i} \overline{\Theta} \cos\theta$$

avec $I_{iec}$ l'intensité mesurée du rayonnement X émergent dudit élément chimique correspondant, $\rho z_o$ la valeur intermédiaire d'épaisseur massique modifiée au cours dudit cycle, $\overline{\chi}_i$ le terme de correction d'absorption dudit élément chimique correspondant calculé au cours dudit cycle, $\xi_i$ le zêta-facteur associé audit élément chimique correspondant, le terme de correction de numéro atomique $\overline{\varphi}_i$ calculé au cours dudit cycle dudit élément chimique correspondant, $\overline{\Theta}$ le terme de correction d'incidence calculé au cours dudit cycle.

**17.** Procédé d'étude d'un objet comportant les étapes suivantes :

- Diviser l'objet en plusieurs zones à étudier,
- Mettre en oeuvre, pour chaque zone, ledit procédé selon l'une quelconque des revendications 1 à 16 en vue de déterminer la valeur d'épaisseur massique correspondante et, pour chaque élément de ladite zone, la valeur de concentration correspondante.

**Patentansprüche**

1. Verfahren zur Untersuchung einer Zone (Z1) eines Objekts (2), wobei die Zone (Z1) eine Massendicke aufweist und mindestens ein chemisches Element umfasst, **dadurch gekennzeichnet, dass** dieses umfasst:

   - einen Schritt der Belichtung (E1) eines Abschnitts der Zone (Z1) des Objekts (2) mit einem Elektronenstrahl (1),
   - einen Schritt der Identifikation (E2) jedes chemischen Elements, das in der Zone (Z1) vorhanden ist, dank des Belichtungsschritts (E1),
   - einen Schritt der Messung (E3), für jedes identifizierte chemische Element, einer entsprechenden Intensität einer Strahlung X, die von dem Objekt (2) aufgrund des Belichtungsschritts (E1) ausgeht,
   - einen Schritt der Bestimmung (E4) eines Werts der Massendicke als Funktion jedes Messschritts (E3),
   - einen Schritt der Bestimmung (E5) eines Werts der Konzentration jedes identifizierten chemischen Elements unter Verwendung des bestimmten Werts der Massendicke,

   und dadurch, dass es einen Initialisierungsschritt (E6) umfasst, in dem ein Zwischenwert der Massendicke $\rho z_0$, wobei $\rho$ die angenommene Dichte ist und $z_0$ die angenommene Dichte des Objekts (2) auf der Höhe der Zone (Z1) ist, und ein Zwischenwert der Konzentration $C_{ic}$ jedes identifizierten chemischen Elements nach Wahl bestimmt werden, insbesondere unter Berücksichtigung, dass die Intensität der entsprechenden ausgehenden Strahlung X gleich der Intensität der Strahlung ist, die in dem Objekt durch das entsprechende chemische Element generiert wird, und dadurch, dass es einen iterativen Zyklus (E7) von Schritten umfasst, umfassend für jede Iteration des Zyklus (E7) :

   - einen Schritt der Berechnung (E7-0) eines Einfallskorrekturterms $\overline{\theta}$, der dazu bestimmt ist, den Einfallswinkel $\theta$ des Elektronenstrahls zu berücksichtigen, und mit der untersuchten Zone (Z1) assoziiert ist,
   - einen Schritt der Einstellung (E7-1), der für jedes identifizierte chemische Element durchgeführt wird, und umfassend:

     ○ einen Schritt der Berechnung (E7-1-1) eines Einfallskorrekturterms $\overline{\theta}_{im}$, der mit dem identifizierten chemischen Element assoziiert ist und dazu bestimmt ist, den Einfallswinkel $\theta$ des Elektronenstrahls (1) zu berücksichtigen,
     ○ einen Schritt der Berechnung (E7-1-2) eines Atomzahlkorrekturterms $\overline{\varphi}_i$ des entsprechenden chemischen Elements unter Verwendung der während des Zyklus berechneten Einfallskorrekturterme $\overline{\theta}$ und $\overline{\theta}_{im}$,
     ○ einen Schritt der Berechnung (E7-1-3) eines Absorptionskorrekturterms $\overline{\chi}_i$ des entsprechenden chemischen Elements unter Verwendung der während des Zyklus berechneten Einfallskorrekturterme $\overline{\theta}$ und $\overline{\theta}_{im}$ und des während des Zyklus berechneten Atomzahlkorrekturterms $\overline{\varphi}_i$,

   - einen Schritt der Modifikation (E7-2) des Zwischenwerts der Massendicke $\rho z_0$ unter Verwendung des während des Zyklus berechneten Einfallskorrekturterms $\overline{\theta}$ und der Terme der Einfallskorrektur $\overline{\theta}_{im}$, der Atomzahlkorrektur $\overline{\varphi}_i$ und der Absorptionskorrektur $\overline{\chi}_i$, die während des Zyklus für jedes chemische Element berechnet werden und eine Funktion jedes Messschritts sind,
   - einen Schritt der Modifikation (E7-3), für jedes chemische Element, des Zwischenwerts der Konzentration $C_{ic}$ des entsprechenden chemischen Elements unter Verwendung des Zwischenwerts der Massendicke $\rho z_0$, wie während des Zyklus modifiziert, des während des Zyklus berechneten Einfallskorrekturterms $\overline{\theta}$ und der Terme der Einfallskorrektur $\overline{\theta}_{im}$, der Atomzahlkorrektur $\overline{\varphi}_i$ und der Absorptionskorrektur $\overline{\chi}_i$, die während des Zyklus berechnet werden und dem chemischen Element entsprechen,

   und dadurch, dass die Iteration gestoppt wird, wenn die Variation, zwischen zwei aufeinanderfolgenden Iterationen, der Zwischenwerte der Massendicke $\rho z_0$ und der Zwischenwerte der Konzentration $C_{ic}$ jedes chemischen Elements kleiner ist als eine assoziierte vorherbestimmte Schwelle, wobei der modifizierte Zwischenwert der Massendicke den bestimmten Wert der Massendicke definiert, und jeder modifizierte Zwischenwert der Konzentration den entsprechenden bestimmten Wert der Konzentration definiert.

2. Verfahren nach Anspruch 1, **dadurch gekennzeichnet, dass** jeder Schritt der Berechnung (E7-0) des Einfallskorrekturterms $\overline{\theta}$ die Lösung der folgenden Gleichung umfasst:

$$\bar{\theta} = \left\{ 1 + \left[ \frac{\rho z_0}{\cos\theta} f(Z_c) - 2\frac{\cos\theta}{\rho} \left( 1 - e^{14(1-\rho)\frac{\rho z_0}{\cos\theta} f(Z_c)} \right) e^{-2\frac{\rho z_0}{\cos\theta} f(Z_c)} \right] \left[ \frac{1}{\cos\theta} - 1 \right] \right\}^{0,6}$$

und dadurch, dass jeder Schritt der Berechnung (E7-1-1) des Einfallskorrekturterms $\bar{\theta}_{im}$ die Lösung der folgenden Gleichung umfasst:

$$\bar{\theta}_{im} = \left\{ 1 + \left[ \frac{\rho z_{im}}{\cos\theta} f_m(E_{is}) - 2\frac{\cos\theta}{\rho} e^{-2\frac{\rho z_{im}}{\cos\theta} f_m(E_{is})} \right] \left[ \frac{1}{\cos\theta} - 1 \right] \right\}^{0,6}$$

wobei $Z_c$ die mittlere Atomzahl des Objekts auf der Höhe der Zone ist, $f(Z_c)$ eine Funktion der mittleren Atomzahl $Z_c$ ist, $z_{im}$ die Maximale der Ionisationstiefe des entsprechenden chemischen Elements ist, $f(E_{is})$ eine Funktion der Ionisationsenergieschwelle $E_{is}$ des betreffenden Energiepegels eines entsprechenden chemischen Elements ist.

3. Verfahren nach dem vorhergehenden Anspruch, **dadurch gekennzeichnet, dass**

$$f(Z_c) = e^{a(LnZ_c)^4 + b(LnZ_c)^3 + c(LnZ_c)^2 + dLnZ_c + e}$$

,

wobei a, b, c, d, e Parameter sind, die durch Monte-Carlo-Simulation bestimmt werden und von der Energie der Elektronen des Elektronenstrahls abhängig sind.

4. Verfahren nach einem der Ansprüche 2 oder 3, **dadurch gekennzeichnet, dass**

$$f_m(E_{is}) = \frac{A E_{is}^m}{(R_p/S_p)_i}$$

, wobei $(R_p/S_p)_i$ das Verhältnis der Rückstreufaktoren $R_p$ und des

Bremsvermögens $S_p$ für das entsprechende reine chemische Element ist, und A und m Parameter sind, die durch Monte-Carlo-Simulation bestimmt werden und vom Energiepegel für das entsprechende chemische Element abhängig sind.

5. Verfahren nach einem der Ansprüche 1 bis 4, **dadurch gekennzeichnet, dass** jeder Schritt der Berechnung (E7-1-2) des Atomzahlkorrekturterms $\bar{\varphi}_i$, der in der folgenden Beziehung

$$\bar{\varphi}_i(\rho z_\theta) = \frac{1 + \alpha(\rho z_\theta)^n}{1 + \frac{\alpha C_{ic}}{\xi_i I_{igco}} \frac{(\rho z_\theta)^{(1+n)}}{(1 + \frac{\beta_i}{(\rho z_\theta)^n})}}$$

verwendet wird, wobei $I_{igco}$ die Intensität pro Zeiteinheit einer Strahlung X ist, die von dem entsprechenden chemischen Element in dem Objekt generiert wird, das als opak für den Elektronenstrahl angesehen wird, $\xi_i$ der Zeta-Faktor ist, der mit dem entsprechenden chemischen Element assoziiert ist, n ein Parameter ist, der von der mittleren Atomzahl Zc des Objekts auf der Höhe der Zone abhängig ist, $\alpha$ ein Parameter ist, der von der mittleren Atomzahl Zc des Objekts auf der Höhe der Zone abhängig ist, $\beta_i$ ein Term ist, der eine Einstellung der Maxima des Terms $\bar{\varphi}_i$ gestattet, und $z_\theta$ die Dicke in der Einfallsrichtung $\theta$ ist, die aus den während des Zyklus berechneten Einfallskorrekturtermen $\bar{\theta}$ und $\bar{\theta}_{im}$ bestimmt wird.

6. Verfahren nach dem vorhergehenden Anspruch, **dadurch gekennzeichnet, dass** der Parameter n durch die folgende Beziehung

$$n = n_1 Ln Z_c + n_2$$

bestimmt wird, wobei die Parameter $n_1$ und $n_2$ durch ein Nomogramm gegeben sind, das den Wert von n als Funktion von $Z_c$ ungeachtet der Leistung des Elektronenstrahls angibt.

7. Verfahren nach einem der Ansprüche 5 oder 6,**dadurch gekennzeichnet, dass** der Parameter $\alpha$ durch die folgende Beziehung

$$\alpha = e^{(\alpha_1 (Ln Z_c)^2 + \alpha_2 Ln Z_c + \alpha_3)}$$

bestimmt wird, wobei $\alpha_1$, $\alpha_2$ und $\alpha_3$ Parameter sind, die von der Initialenergie $E_0$ der Elektronen des Elektronenstrahls abhängig sind.

8. Verfahren nach einem der Ansprüche 5 bis 7, **dadurch gekennzeichnet, dass** der Term $\beta_i$ bestimmt wird, indem festgelegt wird, dass, für jede Dicke größer oder gleich einer maximalen Ionisationstiefe $z_{im}$ des entsprechenden chemischen Elements, die Intensität der Strahlung X, die in dem Objekt (2) generiert wird, äquivalent zu jener des Objekts ist, wenn dieses Letztere für den Elektronenstrahl opak ist.

9. Verfahren nach dem vorhergehenden Anspruch, **dadurch gekennzeichnet, dass** der Term $\beta_i$ durch die Lösung der folgenden Gleichung erhalten wird:

$$\beta_i = \begin{cases} (\rho z_{im})^n \dfrac{\left(\frac{\xi_i}{C_{ic}} \frac{I_{igco}}{\rho z_{im}} - 1\right)}{\alpha (\rho z_{im})^n - \left(\frac{\xi_i}{C_{ic}} \frac{I_{igco}}{\rho z_{im}} - 1\right)}, \\ 0, \end{cases}$$

wenn $\beta_i > 0$
wenn $\leq 0$,
wobei $z_{im}$ die maximale Ionisationstiefe des entsprechenden chemischen Elements ist.

10. Verfahren nach einem der Ansprüche 1 bis 8,
**dadurch gekennzeichnet, dass** jeder Schritt der Berechnung (E7-1-3) des Absorptionskorrekturterms $\bar{\chi}_i$ die Lösung der folgenden Gleichung verwendet:

$$\bar{\chi}_i = \begin{cases} \dfrac{\chi_{ic} \rho z_0 \bar{\varphi}_i(\rho z_\theta)}{\varphi_i(0) + \frac{P_i}{\chi_{ic}} + \left\{ P_i'\left(\frac{1}{\chi_{ic}} - \rho z_0\right) - \left[\varphi_i(0) - \varphi_i(\rho z_0) + \frac{P_i}{\chi_{ic}}\right] + (P_i' - P_i)\rho z_{ib}\right\} e^{-\chi_{ic}\rho z_{ib}} - \left[\varphi_i(\rho z_0) + \frac{P_i'}{\chi_{ic}}\right] e^{-\chi_{ic}\rho z_0}}, \\[3ex] \dfrac{\rho z_0 \chi_{ic} \bar{\varphi}_i(\rho z_\theta)}{\varphi_i(0) + \frac{P_i''}{\chi_{ic}} - \left\{ P_i''\left(\frac{1}{\chi_{ic}} + \rho z_0\right) + \varphi_i(0)\right\} e^{-\chi_{ic}\rho z_0}}, \end{cases}$$

wenn $z_{ib} > 0$
wenn $z_{ib} \leq 0$

wobei $\varphi_i(0)$ der Wert der Verteilung der Intensitäten der Strahlung X ist, die an der Oberfläche des Objekts durch das entsprechende chemische Element generiert wird, $\varphi_i(\rho z_0)$ der Wert der Verteilung der Intensitäten der Strahlung X ist, die in der Tiefe $z_0$ des Objekts durch das entsprechende chemische Element generiert wird, $P_i$ die Initialsteigung der Verteilung der Intensitäten der Strahlung X ist, die an der Oberfläche des Objekts durch das entsprechende chemische Element generiert wird und bestimmt wird durch die Beziehung $P_i = \dfrac{g.h^4.(F/\bar{R})^2}{\bar{\varphi}_i(\rho z_{i\theta})\rho z_{i\theta}} \dfrac{1}{(cos\theta)^4}$, wobei

$$\overline{\varphi}_i(\rho z_{i\theta}) = \frac{1 + \alpha(\rho z_{i\theta})^n}{1 + \frac{\alpha\, C_{ic}}{\xi_i\, I_{igco}} \frac{(\rho z_{i\theta})^{(1+n)}}{(1+\frac{\beta_i}{(\rho z_{i\theta})^n})}} - \quad \text{und} \quad z_{i\theta} = \frac{z_{im}}{\overline{\theta}_{im}cos\theta}, \quad X_{ic} \text{ den Massenabsorptionskoeffizienten der Verbin-}$$

dung für die Strahlung X repräsentiert, die für das entsprechende chemische Element charakteristisch ist, $\overline{\varphi}_i\,(\rho z_\theta)$ der während des Zyklus berechnete Atomzahlkorrekturterm ist,

$$P_i' = \frac{[\varphi_i(0) - \varphi_i(\rho z_0)]^2 + 2 P_i \rho z_0 [\overline{\varphi}_i(\rho z_\theta) - \varphi_i(\rho z_0)]}{\rho z_0 [2\overline{\varphi}_i(\rho z_\theta) - 2\varphi_i(0) - P_i \rho z_0]}, \qquad P_i'' = 2\frac{\overline{\varphi}_i(\rho z_\theta) - \varphi_i(0)}{\rho z_0}, \qquad z_{ib} =$$

$$z_0 \frac{2\overline{\varphi}_i(\rho z_\theta) - \varphi_i(0) - \varphi_i(\rho z_0)}{P_i \rho z_0 + \varphi_i(0) - \varphi_i(\rho z_0)},$$

$z_{im}$ die maximale Ionisationstiefe des entsprechenden chemischen Elements ist, $\beta_i$ ein Term ist, der die Einstellung der Maxima des Atomzahlkorrekturterms gestattet, $I_{igco}$ die Intensität pro Zeiteinheit einer Strahlung X ist, die durch das entsprechende chemische Element in dem Objekt generiert wird, das als opak für den Elektronenstrahl angesehen wird, $\xi_i$ der Zeta-Faktor ist, der mit dem entsprechenden chemischen Element assoziiert ist, $\alpha$ ein Parameter ist, der von der mittleren Atomzahl Zc des Objekts auf der Höhe der Zone (Z1) abhängig ist, n ein Parameter ist, der von der mittleren Atomzahl Zc des Objekts auf der Höhe der Zone abhängig ist, und $z_\theta$ die Tiefe des Objekts auf der Höhe der Zone ist, indem der Einfall $\theta$ des Elektronenstrahls berücksichtigt wird.

11. Verfahren nach dem vorhergehenden Anspruch, **dadurch gekennzeichnet, dass** der Parameter $\varphi_i\,(0)$ auf folgende Weise berechnet wird:

$$\varphi_i(0) = \begin{cases} 1 + [\varphi_{im}(0) - 1]\frac{z_0}{\overline{z}_i}, \\ \varphi_{im}(0), \end{cases}$$

wenn $z_0 < \overline{z}_i$,
wenn $z_0 \geq \overline{z}_i$,

wobei

$$\overline{z}_i = \overline{z}_{ip} \frac{\rho_i}{\rho} \frac{n}{n_i}\left[1 + 0{,}048\left(2{,}5 - \frac{E_0}{20}\right)\left(1 - LnM_i + \frac{(LnM_i)^2}{3}\right)\left(\frac{M_c}{M_i} - 1\right)\right],$$

$\varphi_{im}\,(0)$ die Oberflächenionisation des entsprechenden chemischen Elements in dem Objekt ist, das als opak für den Elektronenstrahl angesehen wird, $\overline{z}_{ip}$ die Dicke ist, für die der Atomzahlkorrekturterm $\overline{\varphi}_i$ des entsprechenden reinen chemischen Elements ein Maximum ist, n und $n_i$ Parameter sind, die jeweils von der mittleren Atomzahl des Objekts und der Atomzahl des reinen chemischen Elements abhängig sind, $\rho_i$ die Dichte des entsprechenden reinen chemischen Elements ist, und $M_c$ und $M_i$ die Atommassen des Objekts und des entsprechenden reinen chemischen Elements sind, und $E_0$ die Initialenergie der Elektronen des Elektronenstrahls ist.

12. Verfahren nach dem vorhergehenden Anspruch, **dadurch gekennzeichnet, dass** dieses einen Schritt der Bestimmung eines Parameters $\overline{z}_{i\theta}$ umfasst, der dem Minimalwert zwischen $\overline{z}_i$ und $z_{i\theta}$ entspricht und durch die folgende Beziehung bestimmt wird: $\overline{z}_{i\theta} = Min\,(\overline{z}_i, z_{i\theta})$.

13. Verfahren nach dem vorhergehenden Anspruch, **dadurch gekennzeichnet, dass** der Term $\varphi_i\,(\rho z_0)$ auf die folgende Weise bestimmt wird: $\varphi_i\,(\rho z_0) =$

$$\begin{cases} \left\{\left[\frac{3}{2}-\varphi_i(0)\right]\frac{z_0}{\bar{z}_{i\theta}}\left[2-\frac{z_0}{\bar{z}_{i\theta}}\right]+\varphi_i(0)\right\}cos\theta, \\ \frac{3}{2}\left\{\left[\frac{z_0-\bar{z}_{i\theta}}{z_{im}-\bar{z}_{i\theta}}\right]\left[\frac{z_0-\bar{z}_{i\theta}}{z_{im}-\bar{z}_{i\theta}}-2\right]+1\right\}cos\theta, \\ 0 \end{cases}$$

wenn $z_0 < \bar{z}_{i\theta}$.
wenn $\bar{z}_{i\theta} \leq z_0 < z_{im}$,
wenn $z_0 < z_{im}$.

**14.** Verfahren nach Anspruch 1, **dadurch gekennzeichnet, dass**, wenn der Einfallswinkel θ null ist, dann die beiden Einfallskorrekturterme $\bar{\theta}$ und $\bar{\theta}_{im}$ gleich 1 sind, so dass der Atomzahlkorrekturterm aus der folgenden Gleichung bestimmt wird: $\bar{\varphi}_i(\rho z_0) =$

$$\frac{1+\alpha(\rho z_0)^n}{1+\frac{\alpha\,C_{ic}}{\xi_i I_{igco}}\frac{(\rho z_0)^{(1+n)}}{(1+\frac{\beta_i}{(\rho z_0)^n})}}$$

wobei $I_{igco}$ die Intensität pro Zeiteinheit einer Strahlung X ist, die von dem entsprechenden chemischen Element in dem Objekt generiert wird, das als opak für den Elektronenstrahl angesehen wird, $\xi_i$ der Zeta-Faktor ist, der mit dem entsprechenden chemischen Element assoziiert ist, n ein Parameter ist, der von der mittleren Atomzahl Zc des Objekts auf der Höhe der Zone abhängig ist, $\alpha$ ein Parameter ist, der von der mittleren Atomzahl Zc des Objekts auf der Höhe der Zone abhängig ist, $\beta_i$ ein Term ist, der eine Einstellung der Maxima des Terms $\bar{\varphi}_i$ gestattet, und dadurch, dass

$$\bar{\chi}_i =$$

$$\begin{cases} \frac{\chi_{ic}\rho z_0\bar{\varphi}_i(\rho z_0)}{\varphi_i(0)+\frac{P_i}{\chi_{ic}}+\left\{P_i'\left(\frac{1}{\chi_{ic}}-\rho z_0\right)-\left[\varphi_i(0)-\varphi_i(\rho z_0)+\frac{P_i}{\chi_{ic}}\right]+(P_i'-P_i)\rho z_{ib}\right\}e^{-\chi_{ic}\rho z_{ib}}-\left[\varphi_i(\rho z_0)+\frac{P_i'}{\chi_{ic}}\right]e^{-\chi_{ic}\rho z_0}}, \\ \frac{\rho z_0\chi_{ic}\bar{\varphi}_i(\rho z_0)}{\varphi_i(0)+\frac{P_i''}{\chi_{ic}}-\left\{P_i''\left(\frac{1}{\chi_{ic}}+\rho z_0\right)+\varphi_i(0)\right\}e^{-\chi_{ic}\rho z_0}}, \end{cases}$$

wenn $Z_{ib} > 0$,
wenn $Z_{ib} \leq 0$,

wobei

$$\varphi_i(\rho z_0) = \begin{cases} \left[\frac{3}{2}-\varphi_i(0)\right]\frac{z_0}{\bar{z}_i}\left[2-\frac{z_0}{\bar{z}_i}\right]+\varphi_i(0), \\ \frac{3}{2}\left\{\left[\frac{z_0-\bar{z}_i}{z_{im}-\bar{z}_i}\right]\left[\frac{z_0-\bar{z}_i}{z_{im}-\bar{z}_i}-2\right]+1\right\}, \\ 0 \end{cases}$$

wenn $z_0 < \bar{z}_i$,
wenn $\bar{z}_i \leq z_0 \leq z_{im}$,
wenn $z_0 < z_{im}$.

$\varphi_i(0)$ der Wert der Verteilung der Intensitäten der Strahlung X ist, die an der Oberfläche des Objekts durch das entsprechende chemische Element generiert wird, $P_i$ die Initialsteigung der Verteilung der Intensitäten der Strahlung X ist, die an der Oberfläche des Objekts durch das entsprechende chemische Element generiert wird und bestimmt wird durch die Beziehung

$$P_i = \frac{g.h^4.(^F/_{\bar{R}})^2}{\bar{\varphi}_i(\rho z_{im})\rho z_{im}},$$

wobei

$$\bar{\varphi}_i(\rho z_{im}) = \frac{1 + \alpha(\rho z_{im})^n}{1 + \frac{\alpha\,C_{ic}}{\xi_i I_{igco}}\frac{(\rho z_{im})^{(1+n)}}{(1 + \frac{\beta_i}{(\rho z_{im})^n})}},$$

$X_{ic}$ den Massenabsorptionskoeffizienten des Objekts für das entsprechende chemische Element repräsentiert,

$$P_i' = \frac{[\varphi_i(0) - \varphi_i(\rho z_0)]^2 + 2P_i\rho z_0[\bar{\varphi}_i(\rho z_0) - \varphi_i(\rho z_0)]}{\rho z_0[2\bar{\varphi}_i(\rho z_0) - 2\varphi_i(0) - P_i\rho z_0]}, \quad P_i'' = 2\frac{\bar{\varphi}_i(\rho z_0) - \varphi_i(0)}{\rho z_0}$$

$$\text{und} \quad z_{ib} = z_0\frac{2\bar{\varphi}_i(\rho z_0) - \varphi_i(0) - \varphi_i(\rho z_0)}{P_i\rho z_0 + \varphi_i(0) - \varphi_i(\rho z_0)},$$

$z_{im}$ die maximale Ionisationstiefe des entsprechenden chemischen Elements ist, $\bar{z}_i = \bar{z}_{ip}\frac{\rho_i}{\rho}\frac{n}{n_i}\Big[1 +$

$0,048\left(2,5 - \frac{E_0}{20}\right)\left(1 - LnM_i + \frac{(LnM_i)^2}{3}\right)\left(\frac{M_c}{M_i} - 1\right)\Big]$, $\bar{z}_i$p die Dicke ist, für die der Atomzahlkorrekturterm $\bar{\varphi}_i$ des entsprechenden reinen chemischen Elements ein Maximum ist, n und $n_i$ Parameter sind, die jeweils von der mittleren Atomzahl des Objekts und der Atomzahl des entsprechenden reinen Elements abhängig sind, $\rho_i$ die Dichte des entsprechenden reinen chemischen Elements ist, und $M_c$ und $M_i$ die Atommassen des Objekts und des entsprechenden reinen chemischen Elements sind, $E_0$ die Initialenergie der Elektronen des Elektronenstrahls ist, $\beta_1$ ein Term ist, der die Einstellung der Maxima des Atomzahlkorrekturterms gestattet, $I_{igco}$ die Intensität pro Zeiteinheit einer Strahlung X ist, die durch das entsprechende chemische Element in dem Objekt generiert wird, das als opak für den Elektronenstrahl angesehen wird, $\xi_i$ der Zeta-Faktor ist, der mit dem entsprechenden chemischen Element assoziiert ist, $\alpha$ ein Parameter ist, der von der mittleren Atomzahl Zc des Objekts auf der Höhe der Zone (Z1) abhängig ist, n ein Parameter ist, der von der mittleren Atomzahl Zc des Objekts auf der Höhe der Zone abhängig ist.

15. Verfahren nach einem der Ansprüche 1 bis 14, **dadurch gekennzeichnet, dass** während jedes Zyklus (E7) der Zwischenwert der Massendicke gemäß der folgenden Formel

$$\rho z_0 = \bar{\theta}\,cos\theta\,\sum_{i=1}^{N}\xi_i\frac{\bar{\chi}_i I_{iec}}{\bar{\varphi}_i}$$

modifiziert wird, wobei N die Gesamtanzahl identifizierter chemischer Elemente ist, i der Index des aktuell untersuchten chemischen Elements ist, $I_{iec}$ die Intensität der ausgehenden Strahlung X ist, die dem chemischen Element mit dem Index i entspricht, $\bar{\chi}_i$ der Absorptionskorrekturterm ist, der während des Zyklus berechnet wird und dem chemischen Element mit dem Index i entspricht, $\xi_i$ der Zeta-Faktor ist, der mit dem entsprechenden chemischen Element mit dem Index i assoziiert ist, der Atomzahlkorrekturterm $\bar{\varphi}_i$ während des Zyklus berechnet wird und dem chemischen Element mit dem Index i entspricht, $\bar{\theta}$ der während des Zyklus berechnete Einfallskorrekturterm ist.

16. Verfahren nach einem der Ansprüche 1 bis 15, **dadurch gekennzeichnet, dass** während jedes Zyklus der Zwischenwert der Konzentration $C_{ic}$ jedes chemischen Elements gemäß der folgenden Formel:

$$C_{ic} = \frac{\xi_i}{\rho z_0} \frac{\overline{\chi_i} I_{iec}}{\overline{\varphi_i}} \, \overline{\theta} \, cos\theta$$

berechnet wird, wobei $I_{iec}$ die gemessene Intensität der Strahlung X ist, die von dem entsprechenden chemischen Element ausgeht, $\rho z_0$ der während des Zyklus modifizierte Zwischenwert der Massendicke ist, $\overline{\chi_i}$ der Absorptions-korrekturterm des entsprechenden chemischen Elements ist, der während des Zyklus berechnet wird, $\xi_i$ der zeta-Faktor ist, der mit dem entsprechenden chemischen Element assoziiert ist, der Atomzahlkorrekturterm $\overline{\varphi_i}$ des ent-sprechenden chemischen Elements während des Zyklus berechnet wird, $\overline{\theta}$ der während des Zyklus berechnete Einfallskorrekturterm ist.

17. Verfahren zur Untersuchung eines Objekts, umfassend die folgenden Schritte:

    - Teilen des Objekts in mehrere zu untersuchende Zonen,
    - Durchführen, für jede Zone, des Verfahrens nach einem der Ansprüche 1 bis 16 zur Bestimmung des entsprechenden Massendickenwerts und, für jedes Element der Zone, des entsprechenden Konzentrationswerts.

**Claims**

1. Method for studying a zone (Z1) of an object (2), the said zone (Z1) exhibiting a mass-thickness and comprising at least one chemical element, **characterized in that** it comprises:

    - a step (E1) of exposing a part of the zone (Z1) of the object (2) to an electron beam (1),
    - a step (E2) of identifying each chemical element present in the said zone (Z1) by virtue of the exposure step (E1),
    - a step (E3) of measuring, for each chemical element identified, a corresponding intensity of an X-ray radiation emergent from the object (2) on account of the said exposure step (E1),
    - a step (E4) of determining a value of the said mass-thickness dependent on each measurement step (E3),
    - a step (E5) of determining a value of the concentration of each chemical element identified using the said value of the mass-thickness determined,

and **in that** it comprises an initialization step (E6) in which an intermediate value of the mass-thickness $\rho z_0$, with $\rho$ the assumed density and $z_0$ the assumed thickness of the object (2) at the level of the said zone (Z1), and an intermediate value of concentration $C_{ic}$ of each chemical element identified are determined by choice, especially by considering that the intensity of the corresponding emergent X-ray radiation is equal to the intensity of the radiation generated in the object by the said corresponding chemical element, and **in that** it comprises an iterative cycle (E7) of steps comprising for each iteration of the said cycle (E7):

    - a step (E7-0) of calculating an incidence correction term $\overline{\Theta}$ intended to take account of the angle of incidence $\theta$ of the electron beam and associated with the zone (Z1) studied,
    - a fitting step (E7-1), implemented for each chemical element identified, and comprising:

        o a step (E7-1-1) of calculating an incidence correction term $\overline{\Theta}_{im}$ associated with the said chemical element identified and intended to take account of the angle of incidence $\theta$ of the electron beam (1),
        o a step (E7-1-2) of calculating an atomic number correction term $\overline{\varphi_i}$ for the said corresponding chemical element using the incidence correction terms $\overline{\Theta}$ and $\overline{\Theta}_{im}$ calculated in the course of the said cycle,
        o a step (E7-1-3) of calculating an absorption correction term $\overline{\chi_i}$ for the said corresponding chemical element using the incidence correction terms $\overline{\Theta}$ and $\overline{\Theta}_{im}$ calculated in the course of the said cycle and the atomic number correction term $\overline{\varphi_i}$ calculated in the course of the said cycle,

    - a step (E7-2) of modifying the intermediate value of mass-thickness $\rho z_0$ using the incidence correction term $\overline{\Theta}$ calculated in the course of the said cycle and the incidence correction $\overline{\Theta}_{im}$, atomic number correction $\overline{\varphi_i}$ and absorption correction $\overline{\chi_i}$ terms calculated in the course of the said cycle for each chemical element and dependent on each measurement step,
    - a step (E7-3) of modifying, for each chemical element, the intermediate value of concentration $C_{ic}$ of the said corresponding chemical element using the intermediate value of mass-thickness $\rho z_0$ as modified in the course of the said cycle, the incidence correction term $\overline{\Theta}$, calculated in the course of the said cycle, and the incidence correction $\overline{\Theta_{im}}$, atomic number correction $\overline{\varphi_i}$ and absorption correction $\overline{\chi_i}$ terms calculated in the course of the said cycle and corresponding to the said chemical element,

and **in that** the iteration is halted when the variation, between two successive iterations of the intermediate values of mass-thickness $\rho z_0$ and of the intermediate values of concentration $C_{ic}$ of each chemical element, is less than an associated predetermined threshold, the said modified intermediate mass-thickness value defining the mass-thickness value determined and each modified intermediate concentration value defining the corresponding concentration value determined.

2. Method according to Claim 1, **characterized in that** each step (E7-0) of calculating the incidence correction term $\overline{\Theta}$ comprises the solving of the following equation:

$$\bar{\Theta} =$$

$$\left\{1 + \left[\frac{\rho z_0}{\cos\theta} f(Z_c) - 2\frac{\cos\theta}{\rho}\left(1 - e^{14(1-\rho)\frac{\rho z_0}{\cos\theta}f(Z_c)}\right) e^{-2\frac{\rho z_0}{\cos\theta}f(Z_c)}\right]\left[\frac{1}{\cos\theta} - 1\right]\right\}^{0.6}$$

and **in that** each step (E7-1-1) of calculating the incidence correction term $\overline{\Theta_{im}}$ comprises the solving of the following equation:

$$\bar{\Theta}_{im} = \left\{1 + \left[\frac{\rho z_{im}}{\cos\theta} f_m(E_{is}) - 2\frac{\cos\theta}{\rho} e^{-2\frac{\rho z_{im}}{\cos\theta}f_m(E_{is})}\right]\left[\frac{1}{\cos\theta} - 1\right]\right\}^{0.6}$$

with $Z_c$ the mean atomic number of the object at the level of the said zone, $f(Z_c)$ a function of the mean atomic number $Z_c$, $z_{im}$ the maximum ionization depth of the corresponding chemical element, $f_m(E_{is})$ a function of the ionization threshold energy $E_{is}$ of the energy level considered of a corresponding chemical element.

3. Method according to the preceding claim, **characterized in that** $f(Z_c) = e^{a(LnZ_c)^4 + b(LnZ_c)^3 + c(LnZ_c)^2 + d(LnZ_c) + e}$, with a, b, c, d, e parameters determined by Monte-Carlo simulation and depending on the energy of the electrons of the said electron beam.

4. Method according to one of Claims 2 and 3, **characterized in that** $f_m(E_{is}) = \dfrac{A E_{is}^m}{(R_p/S_p)_i}$ with $(R_p/S_p)_i$ being the ratio of the backscattering coefficients Rp and of the stopping power Sp for the corresponding pure chemical element, and A and m parameters determined by Monte-Carlo simulation and depending on the energy level for the said corresponding chemical element.

5. Method according to one of Claims 1 to 4, **characterized in that** each step (E7-1-2) of calculating the atomic number correction term $\overline{\varphi_i}$ uses the following relation $\overline{\varphi}_i(\rho z_\theta) = \dfrac{1 + \alpha(\rho z_\theta)^n}{1 + \frac{\alpha\, C_{ic}}{\xi_i\, I_{igco}}\frac{(\rho z_\theta)^{(1+n)}}{(1 + \frac{\beta_i}{(\rho z_\theta)^n})}}$ with $I_{igco}$ the intensity per unit time of an X-ray radiation generated by the corresponding chemical element in the object considered to be opaque to the said electron beam, $\xi_i$ the zeta-factor associated with the said corresponding chemical element, $n$ a parameter depending on the mean atomic number Zc of the object at the level of the said zone, $\alpha$ a parameter depending on the mean atomic number Zc of the object at the level of the said zone, $\beta_i$ term making it possible to fit the maximum of the term $\overline{\varphi_i}$ and $z_\theta$ the thickness in the direction of incidence θ determined on the basis of the incidence correction terms $\overline{\Theta}$ and $\overline{\Theta_{im}}$ calculated in the course of the said cycle.

6. Method according to the preceding claim, **characterized in that** the parameter $n$ is determined by the following

relation $n = n_1 LnZ_c + n_2$, the parameters $n_1$ and $n_2$ being given by a chart giving the value of $n$ as a function of $Z_c$ whatever the power of the electron beam.

7. Method according to one of Claims 5 and 6, **characterized in that** the parameter $\alpha$ is determined by the following relation $\alpha = e^{(\alpha_1(LnZ_c)^2 + \alpha_2(LnZ_c) + \alpha_3)}$, with $\alpha_1$, $\alpha_2$ and $\alpha_3$ parameters depending on the initial energy $E_0$ of the electrons of the electron beam.

8. Method according to one of Claims 5 to 7, **characterized in that** the term $\beta_i$ is determined by supposing that, for any thickness greater than or equal to a maximum ionization depth $z_{im}$ of the corresponding chemical element, the intensity of the X-ray radiation generated in the object (2) is equivalent to that of the object if the latter is opaque to the said electron beam.

9. Method according to the preceding claim, **characterized in that** the term $\beta_i$ is obtained by solving the following equation:
$$\beta_i = \begin{cases} (\rho z_{im})^n \dfrac{\left(\frac{\xi_i}{C_{ic}} \frac{I_{igco}}{\rho z_{im}} - 1\right)}{\alpha(\rho z_{im})^n - \left(\frac{\xi_i}{C_{ic}} \frac{I_{igco}}{\rho z_{im}} - 1\right)}, & if\ \beta_i > 0 \\ 0, & if\ \beta_i \leq 0 \end{cases}$$
, with $z_{im}$ the maximum ionization depth of the corresponding chemical element.

10. Method according to one of Claims 1 to 8, **characterized in that** each step (E7-1-3) of calculating the absorption correction term $\overline{\chi_i}$ makes use of solving the equation

$$\bar{\chi}_i = \begin{cases} \dfrac{\chi_{ic}\rho z_0 \overline{\varphi}_i(\rho z_\theta)}{\varphi_i(0) + \frac{P_i}{\chi_{ic}} + \left\{P_i'\left(\frac{1}{\chi_{ic}} - \rho z_0\right) - \left[\varphi_i(0) - \varphi_i(\rho z_0) + \frac{P_i}{\chi_{ic}}\right] + (P_i' - P_i)\rho z_{ib}\right\}e^{-\chi_{ic}\rho z_{ib}} - \left[\varphi_i(\rho z_0) + \frac{P_i'}{\chi_{ic}}\right]e^{-\chi_{ic}\rho z_0}}, & if\ z_{ib} > 0 \\ \dfrac{\rho z_0 \chi_{ic} \overline{\varphi}_i(\rho z_\theta)}{\varphi_i(0) + \frac{P_i''}{\chi_{ic}} - \left\{P_i''\left(\frac{1}{\chi_{ic}} + \rho z_0\right) + \varphi_i(0)\right\}e^{-\chi_{ic}\rho z_0}}, & if\ z_{ib} \leq 0 \end{cases}$$

with $\varphi_i (0)$ *the* value of the distribution of the intensities of the *X-ray* radiation generated at the surface of the object by the corresponding chemical element, $\varphi_i (\rho z_0)$ the value of the distribution of the intensities of the *X-ray* radiation generated at the depth $z_0$ of the object by the corresponding chemical element, $P_i$ the initial slope of the distribution of the intensities of the *X-ray* radiation generated at the surface of the object by the corresponding chemical element and determined by the relation $P_i = \dfrac{g.h^4.(F/\bar{R})^2}{\overline{\varphi}_i(\rho z_{i\theta})\rho z_{i\theta}} \dfrac{1}{(cos\theta)^4}$ with $\overline{\varphi}_i(\rho z_{i\theta}) = \dfrac{1 + \alpha(\rho z_{i\theta})^n}{1 + \frac{\alpha C_{ic}}{\xi_i I_{igco}} \frac{(\rho z_{i\theta})^{(1+n)}}{(1 + \frac{\beta_i}{(\rho z_{i\theta})^n})}}$ and

$z_{i\theta} = \dfrac{z_{im}}{\overline{\Theta}_{im}cos\theta}$, $\chi_{ic}$ representing the mass absorption coefficient of the compound for the characteristic *X-ray* radiation of the corresponding chemical element, $\overline{\varphi}_i (\rho z_\theta)$ being the atomic number correction term calculated in the course of the said cycle, $P_i' = \dfrac{[\varphi_i(0) - \varphi_i(\rho z_0)]^2 + 2P_i\rho z_0[\overline{\varphi}_i(\rho z_\theta) - \varphi_i(\rho z_0)]}{\rho z_0[2\overline{\varphi}_i(\rho z_\theta) - 2\varphi_i(0) - P_i\rho z_0]}$, $P_i'' = 2\dfrac{\overline{\varphi}_i(\rho z_\theta) - \varphi_i(0)}{\rho z_0}$,

$z_{ib} = z_0 \dfrac{2\overline{\varphi}_i(\rho z_\theta) - \varphi_i(0) - \varphi_i(\rho z_0)}{P_i\rho z_0 + \varphi_i(0) - \varphi_i(\rho z_0)}$, $z_{im}$ the maximum ionization depth of the corresponding chemical element, $\beta_i$ a term making it possible to fit the maximum of the atomic number correction term, $I_{igco}$ the intensity per unit time of an *X-ray* radiation generated by the corresponding chemical element in the object considered to be opaque to the said electron beam, $\xi_i$ the zeta-factor associated with the said corresponding chemical element, $\alpha$ a parameter depending on the mean atomic number Zc of the object at the level of the said zone *(Z1)*, n a parameter depending on the mean atomic number Zc of the object at the level of the said zone and $z_\theta$ the depth of the object at the level of the said zone while taking account of the incidence $\theta$ of the electron beam.

**11.** Method according to the preceding claim, **characterized in that** the parameter $\varphi_i(0)$ is calculated in the following manner:

$$\varphi_i(0) = \begin{cases} 1 + [\varphi_{im}(0) - 1]\frac{z_0}{\bar{z}_i}, & \text{if} \quad z_0 < \bar{z}_i \\ \varphi_{im}(0), & if \quad z_0 \geq \bar{z}_i \end{cases} \quad \text{with} \quad \bar{z}_i = \bar{z}_{ip}\frac{\rho_i}{\rho}\frac{n}{n_i}\Big[1 +$$

$$0.048\left(2.5 - \frac{E_0}{20}\right)\left(1 - LnM_i + \frac{(LnM_i)^2}{3}\right)\left(\frac{M_c}{M_i} - 1\right)\Big], \quad \varphi_{im}(0)$$ the surface ionization of the corresponding chemical element in the object considered to be opaque to the said electron beam, $\bar{z}_{ip}$ the thickness for which the atomic number correction term $\bar{\varphi}_i$ for the corresponding pure chemical element is a maximum, $n$ and $n_i$ parameters depending respectively on the mean atomic number of the object and on the atomic number of the pure chemical element, $\rho_i$ the density of the corresponding pure chemical element and $M_c$ and $M_i$ the atomic masses of the object and of the corresponding pure chemical element, and $E_0$ the initial energy of the electrons of the electron beam.

**12.** Method according to the preceding claim **characterized in that** it comprises a step of determining a parameter $\bar{z}_{i\theta}$ corresponding to the minimum value between $\bar{z}_i$ and $z_{i\theta}$ and defined by the following relation:

$$\bar{z}_{i\theta} = Min(\bar{z}_i, z_{i\theta}).$$

**13.** Method according to the preceding claim, **characterized in that** the term $\varphi_i(\rho z_0)$ is determined in the following manner: $\varphi_i(\rho z_0) =$

$$\begin{cases} \left\{\left[\frac{3}{2} - \varphi_i(0)\right]\frac{z_0}{\bar{z}_{i\theta}}\left[2 - \frac{z_0}{\bar{z}_{i\theta}}\right] + \varphi_i(0)\right\}\cos\theta, & \text{if} \quad z_0 < \bar{z}_{i\theta} \\ \frac{3}{2}\left\{\left[\frac{z_0 - \bar{z}_{i\theta}}{z_{im} - \bar{z}_{i\theta}}\right]\left[\frac{z_0 - \bar{z}_{i\theta}}{z_{im} - \bar{z}_{i\theta}} - 2\right] + 1\right\}\cos\theta, & if \quad \bar{z}_{i\theta} \leq z_0 \leq z_{im} \\ 0 & if \quad z_0 > z_{im} \end{cases}$$

**14.** Method according to Claim 1, **characterized in that** the angle of incidence $\theta$ being zero then the two incidence correction terms $\overline{\Theta}$ and $\overline{\Theta}_{im}$ are equal to 1 so that the atomic number correction term is determined on the basis of the following equation $\varphi_i(\rho z_0) = \dfrac{1 + \alpha(\rho z_0)^n}{1 + \dfrac{\alpha\,C_{ic}}{\xi_i\,I_{igco}}\dfrac{(\rho z_0)^{(1+n)}}{(1 + \dfrac{\beta_i}{(\rho z_0)^n})}}$ with $I_{igco}$ the intensity per unit time of an X-ray radiation generated by the corresponding chemical element in the object considered to be opaque to the said electron beam, $\xi_i$ the zeta-factor associated with the said corresponding chemical element, $n$ a parameter depending on the mean atomic number $Zc$ of the object at the level of the said zone, $\alpha$ a parameter depending on the mean atomic number $Zc$ of the object at the level of the said zone, $\beta_i$ a term making it possible to fit the maximum of the term $\bar{\varphi}_i$, and **in that**

$$\bar{\chi}_i =$$

$$\begin{cases} \dfrac{\chi_{ic}\rho z_0\bar{\varphi}_i(\rho z_0)}{\varphi_i(0) + \frac{P_i}{\chi_{ic}} + \left\{P_i'\left(\frac{1}{\chi_{ic}} - \rho z_0\right) - \left[\varphi_i(0) - \varphi_i(\rho z_0) + \frac{P_i}{\chi_{ic}}\right] + (P_i' - P_i)\rho z_{ib}\right\}e^{-\chi_{ic}\rho z_{ib}} - \left[\varphi_i(\rho z_0) + \frac{P_i'}{\chi_{ic}}\right]e^{-\chi_{ic}\rho z_0}}, & \text{if } z_{ib} > 0 \\[20pt] \dfrac{\rho z_0\chi_{ic}\bar{\varphi}_i(\rho z_0)}{\varphi_i(0) + \frac{P_i''}{\chi_{ic}} - \left\{P_i''\left(\frac{1}{\chi_{ic}} + \rho z_0\right) + \varphi_i(0)\right\}e^{-\chi_{ic}\rho z_0}}, & \text{if } z_{ib} \leq 0 \end{cases}$$

with

$$\varphi_i(\rho z_0) = \begin{cases} \left[\frac{3}{2} - \varphi_i(0)\right] \frac{z_0}{\bar{z}_i}\left[2 - \frac{z_0}{\bar{z}_i}\right] + \varphi_i(0), & \text{if} \quad z_0 < \bar{z}_i \\ \frac{3}{2}\left\{\left[\frac{z_0 - \bar{z}_i}{z_{im} - \bar{z}_i}\right]\left[\frac{z_0 - \bar{z}_i}{z_{im} - \bar{z}_i} - 2\right] + 1\right\}, & \text{if} \quad \bar{z}_i \leq z_0 \leq z_{im}, \\ 0 & \text{if} \quad z_0 > z_{im} \end{cases}$$

$\varphi_i(0)$ the value of the distribution of the intensities of the *X-ray* radiation generated at the surface of the object by the corresponding chemical element, $P_i$ the initial slope of the distribution of the intensities of the *X-ray* radiation generated at the surface of the object by the corresponding chemical element and determined by the relation

$$P_i = \frac{g.h^4.(F/\bar{R})^2}{\bar{\varphi}_i(\rho z_{im})\rho z_{im}} \text{ with } \bar{\varphi}_i(\rho z_{im}) = \frac{1 + \alpha(\rho z_{im})^n}{1 + \frac{\alpha\, C_{ic}}{\xi_i\, I_{igco}}\frac{(\rho z_{im})^{(1+n)}}{(1 + \frac{\beta_i}{(\rho z_{im})^n})}}, \quad \chi_{ic}$$ representing the mass absorption coefficient of the object for the corresponding chemical element $P_i' = \frac{[\varphi_i(0) - \varphi_i(\rho z_0)]^2 + 2P_i\rho z_0[\bar{\varphi}_i(\rho z_0) - \varphi_i(\rho z_0)]}{\rho z_0[2\bar{\varphi}_i(\rho z_0) - 2\varphi_i(0) - P_i\rho z_0]}$,

$P_i'' = 2\frac{\bar{\varphi}_i(\rho z_0) - \varphi_i(0)}{\rho z_0}$, and $z_{ib} = z_0\frac{2\bar{\varphi}_i(\rho z_0) - \varphi_i(0) - \varphi_i(\rho z_0)}{P_i\rho z_0 + \varphi_i(0) - \varphi_i(\rho z_0)}$, $z_{im}$ the maximum ionization depth of the

corresponding chemical element, $\bar{z}_i = \bar{z}_{ip}\frac{\rho_i}{\rho}\frac{n}{n_i}\left[1 + 0.048\left(2.5 - \frac{E_0}{20}\right)\left(1 - \right.\right.$, $\bar{z}_{ip}$ the thickness for which the atomic number correction term $\bar{\varphi}_i$ for the corresponding pure chemical element is a maximum, $n$ and $n_i$ parameters depending respectively on the mean atomic number of the object and on the atomic number of the corresponding pure element, $\rho_i$ the density of the corresponding pure chemical element and $M_c$ and $M_i$ the atomic masses of the object and of the corresponding pure chemical element, $E_0$ the initial energy of the electrons of the electron beam, $\beta_i$ a term making it possible to fit the maximum of the atomic number correction term, $I_{igco}$ the intensity per unit time of an *X-ray* radiation generated by the corresponding chemical element in the object considered to be opaque to the said electron beam, $\xi_i$ the zeta-factor associated with the said corresponding chemical element, $\alpha$ a parameter depending on the mean atomic number *Zc* of the object at the level of the said zone *(Z1)*, $n$ a parameter depending on the mean atomic number *Zc* of the object at the level of the said zone.

15. Method according to any one of Claims 1 to 14, **characterized in that** in the course of each cycle (E7) the intermediate value of the mass-thickness is modified according to the following formula $\rho z_0 = \bar{\Theta}\,cos\theta\sum_{i=1}^{N}\xi_i\frac{\overline{\chi_i}I_{iec}}{\bar{\varphi}_i}$ with N the total number of chemical elements identified, i the index of the current chemical element studied, $I_{iec}$ the intensity of the emergent *X-ray* radiation corresponding to the said chemical element of index i, $\overline{\chi_i}$ the absorption correction term calculated in the course of the said cycle and corresponding to the said chemical element of index i, $\xi_i$ the zeta-factor associated with the said chemical element of index i, the atomic number correction term $\bar{\varphi}_i$ calculated in the course of the said cycle and corresponding to the said chemical element of index i, $\overline{\Theta}$ the incidence correction term calculated in the course of the said cycle.

16. Method according to any one of Claims 1 to 15, **characterized in that** in the course of each cycle the intermediate value of concentration $C_{ic}$ of each chemical element is calculated according to the following formula:

$$C_{ic} = \frac{\xi_i}{\rho z_0}\frac{\overline{\chi_i}I_{iec}}{\bar{\varphi}_i}\overline{\Theta}cos\theta$$ with $I_{iec}$ the measured intensity of the emergent *X-ray* radiation of the said corresponding

chemical element, $\rho z_0$ the intermediate mass-thickness value modified in the course of the said cycle, $\overline{\chi_i}$ the absorption correction term for the said corresponding chemical element calculated in the course of the said cycle, $\xi_i$ the zeta-factor associated with the said corresponding chemical element, the atomic number correction term $\bar{\varphi}_i$ calculated

in the course of the said cycle for the said corresponding chemical element, $\overline{\Theta}$ the incidence correction term calculated in the course of the said cycle.

17. Method for studying an object comprising the following steps:

- Dividing the object into several zones to be studied,
- Implementing, for each zone, the said method according to any one of Claims 1 to 16 with a view to determining the corresponding mass-thickness value and, for each element of the said zone, the corresponding concentration value.

Figure 1

Figure 2

Figure 3

$$y = 0.0314x^4 - 0.4661x^3 + 2.2686x^2 - 3.8452x - 7.6463$$

Figure 4

Figure 5

Figure 6

Figure 7

Figure 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **WATANABE M. ; WILLIAMS D.B.** The quantitative analysis of thin specimens : a review of progress from the Cliff-Lorimer to the new $\xi$-factor methods. *Journal of Microscopy,* 2006, vol. 221, 89-109
- Quantitative analysis of homogeneous or stratified microvolumes applying the model PAP. **POUCHOU J.L. ; PICHOIR F.** Electron Probe Quantitation. Plenum Press, 1991, 31, , 40
- Quantitative analysis of homogeneous or stratified microvolumes applying the model PAP. **POUCHOU J.L. ; PICHOIR F.** Electron Probe Quantitation. Plenum Press, 1991, 31